# EUROPEAN PATENT APPLICATION

(11) **EP 4 410 860 A1**
(43) Date of publication of application: **07.08.2024**
(21) Application number: 22876288.6
(22) Date of filing: 28.09.2022
(51) Int. Cl.: C08G 63/133

(54) **POLYESTER RESIN**

(30) Priority: 01.10.2021 JP 2021163004
(71) Applicant: AJINOMOTO CO., INC., Chuo-ku Tokyo 104-8315 (JP)
(72) Inventor: OGURA, Ichiro, Kawasaki-shi, Kanagawa 210-0801 (JP); SATO, Naoya, Kawasaki-shi, Kanagawa 210-0801 (JP)
(74) Representative: Mewburn Ellis LLP
(86) International application number: PCT/JP2022/036061
(87) International publication number: WO 2023/054422

(57) **Abstract**

The present invention provides a polyester resin which achieves a cured product exhibiting excellent dielectric properties and also favorable mechanical properties in combination with a cross-linkable resin. The polyester resin contains a structural unit represented by the following general formula (1), and has an aromatic oxycarbonyl group at its terminal: 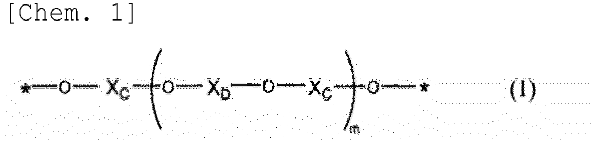 (in the formula,
X_{C}s each independently represent a divalent organic group containing at least one aromatic ring,
X_{D}s each independently represent a divalent organic group,
m is an average value of the number of repetitions, and is a number satisfying 0 < m ≤ 10, and
* indicates a bond).

## Description

### TECHNICAL FIELD

The present invention relates to a polyester resin. Furthermore, the present invention relates to a resin composition, a resin sheet, a prepreg, a cured product, a printed wiring board, a semiconductor chip package and a semiconductor device, which are obtained using the polyester resin.

### BACKGROUND ART

A resin composition containing a cross-linkable resin such as an epoxy resin and a cross-linking agent (curing agent) for the resin is widely used as a material for an electronic component such as a semiconductor package or a printed wiring board, since it produces a cured product that is excellent in insulation, heat resistance, adhesion, and the like.

On the other hand, a high-speed communication such as a 5th generation mobile communication system (5G) has a problem of transmission loss in an operation under a high-frequency environment. To cope with such problems, an insulation material with excellent dielectric properties (low dielectric constant and low dielectric loss tangent) is required. Furthermore, in a printed wiring board, as the wiring becomes finer and the shape becomes thinner, a problem such as cracks and the like around the vias tends to occur more easily. In order to prevent this, there is a strong demand for excellent mechanical properties, specifically high fracture elongation in the insulation material.

As an insulation resin material having excellent dielectric properties, for example, Patent Literature 1 discloses, as a cross-linking agent for an epoxy resin, an active ester resin which is a reaction product of a divalent aromatic hydroxy compound and an aromatic diacid chloride.

### RELATED ART REFERENCE

### Patent Literature

Patent Literature 1: Japanese Patent Application Laid-Open No. 2009-235165 A

### SUMMARY OF INVENTION

### PROBLEM TO BE SOLVED BY THE INVENTION

The active ester resin described in Patent Literature 1 has significantly excellent dielectric properties as compared with a conventional phenol-based cross-linking agent and the like. However, the transmission loss thereof does not meet a sufficiently satisfactory standard that is required for 5G applications. Furthermore, as an adverse effect of the ester crosslinking, the obtained cured product is hard and brittle. Thus, when the cured product is used in a printed wiring board, there is a problem that cracks around vias are likely to occur.

An object of the present invention is to provide a polyester resin that achieves a cured product exhibiting excellent dielectric properties and also favorable mechanical properties in combination with a cross-linkable resin.

### MEANS FOR SOLVING PROBLEM

As a result of intensive studies, the present inventors have found that the above-mentioned problem can be solved by a polyester resin having the following configuration, and have thereby completed the present invention.

That is, the present invention includes the following contents.
[1] A polyester resin (X) containing a structural unit represented by the following general formula (1), the polyester resin (X) having an aromatic oxycarbonyl group at its terminal: 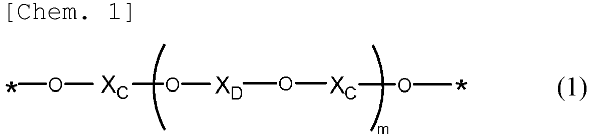 (in the formula,
   X_{C}s each independently represent a divalent organic group containing at least one aromatic ring,
   X_{D}s each independently represent a divalent organic group,
   m is an average value of a number of repetitions, and is a number satisfying 0 < m ≤ 10, and
   * indicates a bond).
[2] The polyester resin (X) according to [1], wherein the X_{D} represents
   (i) a divalent aliphatic hydrocarbon group, or
   (ii) a divalent organic group represented by the following formula (d2-1) or (d2-2): 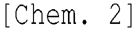 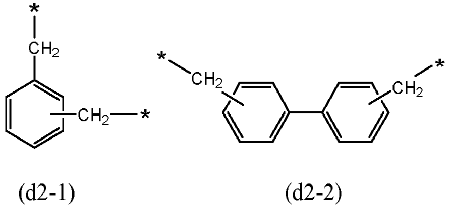 (in the formula, * represents a bond).
[3] The polyester resin (X) according to [1] or [2], wherein an oxygen atom bonded to the X_{C} in the general formula (1) is bonded to an aromatic carbon of the X_{C}.
[4] The polyester resin (X) according to any one of [1] to [3], wherein the X_{C}s are each independently represented by the following formula (C-1), formula (C-2), or formula (C-3) : 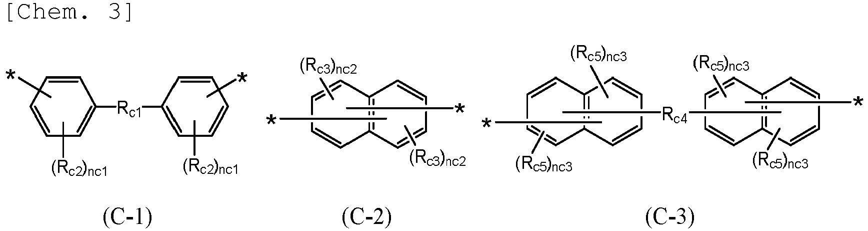 (in the formulas,
   R_{c1}s and R_{c4}s each independently represent a single bond, or a divalent linking group selected from the group consisting of a divalent hydrocarbon group of 1 to 10 carbon atoms optionally having a substituent, an oxygen atom, a sulfonyl group, a carbonyl group, a carbonate group, and a combination thereof,
   R_{c2}s, R_{c3}s, and R_{c5}s each independently represent a substituent,
   nc1, nc2, and nc3 each independently represent a number of 0 to 4, and
   * indicates a bond).
[5] The polyester resin (X) according to any one of [1] to [4], wherein m is a number satisfying 0 < m ≤ 3.
[6] The polyester resin (X) according to any one of [1] to [5], represented by the following general formula (X): 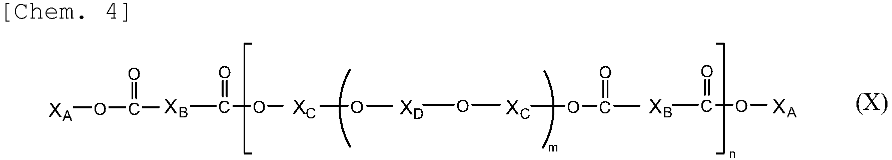 (in the formula,
   X_{C}, X_{D} and m are the same as above,
   X_{A}s each independently represent a monovalent aromatic group,
   X_{B}s each independently represent a divalent organic group, and
   n represents an average value of the number of repetitions, and is a number satisfying 0 < n ≤ 10).
[7] The polyester resin (X) according to [6], wherein the X_{A}s are each independently represented by the following formula (A-1) or (A-2): 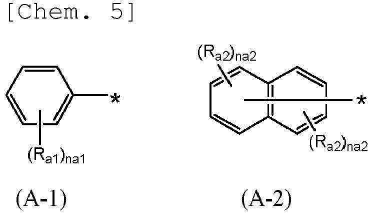 (in the formulas,
   Rₐ₁ and Rₐ₂ each independently represent a substituent,
   na1 represents a number of 0 to 5,
   na2s each independently represent a number of 0 to 4, and
   * represents a bond).
[8] The polyester resin (X) according to [6] or [7], wherein m is a number satisfying 0 < m ≤ 3, and n is a number satisfying 0 < n ≤ 3.
[9] The polyester resin (X) according to any one of [1] to [8], wherein the polyester resin (X) is a condensation reaction product of:
   (x1) an aromatic dihydroxy oligomer compound represented by the following general formula (x1);
   (x2) a divalent organic carboxylic acid compound or a divalent organic carboxylic acid halide compound; and
   (x3) a monovalent hydroxy compound having an aromatic hydroxy group: 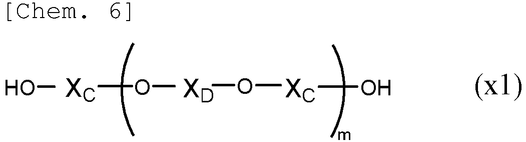 (in the formula, X_{C}, X_{D}, and m are the same as described above) .
[10] The polyester resin (X) according to [9], wherein the aromatic dihydroxy oligomer compound (x1) is a dehydrohalogenation reaction product of a divalent aromatic hydroxy compound represented by the following general formula (x1-c), and a divalent organic halide compound represented by the following general formula (x1-d):

   [Chem. 7] HO-X_{C}-OH (x1-c)

   (in the formula, X_{C} is the same as described above); and

   [Chem. 8] Y-X_{D}-Y (xl-d)

   (in the formula, X_{D} is the same as described above, and Y represents a halogen atom).
[11] The polyester resin (X) according to [10], wherein a hydroxyl equivalent of the divalent aromatic hydroxy compound is 150 g/eq. or more.
[12] The polyester resin (X) according to any one of [9] to [11], wherein a hydroxyl equivalent of the aromatic dihydroxy oligomer compound (x1) is 250 g/eq. or more.
[13] The polyester resin (X) according to any one of [1] to [12], wherein an equivalent weight of an active ester group is 250 g/eq. or more.
[14] A resin cross-linking agent comprising the polyester resin (X) according to any one of [1] to [13].
[15] A resin composition comprising the polyester resin (X) according to any one of [1] to [13], and a cross-linkable resin (Y).
[16] The resin composition according to [15], wherein the cross-linkable resin (Y) is one or more types selected from the group consisting of a thermosetting resin and a radically polymerizable resin.
[17] The resin composition according to [15] or [16], further comprising an inorganic filler.
[18] The resin composition according to any one of [15] to [17], further comprising an organic solvent.
[19] The resin composition according to any one of [15] to [18], for an insulation layer of a printed wiring board.
[20] The resin composition according to any one of [15] to [18], for sealing semiconductor.
[21] A resin sheet comprising: a support; and a layer of the resin composition according to any one of [15] to [20], disposed on the support.
[22] The resin sheet according to [21], wherein the support is a thermoplastic resin film or a metal foil.
[23] A prepreg formed by impregnating a sheet-like fiber substrate with the resin composition according to any one of [15] to [20].
[24] A cured product of the resin composition according to any one of [15] to [20].
[25] A printed wiring board comprising an insulation layer formed of a cured product of the resin composition according to any one of [15] to [19].
[26] A semiconductor chip package comprising a sealing layer formed of a cured product of the resin composition according to any one of [15] to [18], [20].
[27] The semiconductor chip package according to [26], wherein the semiconductor chip package is a fan-out type package.
[28] A semiconductor device comprising the printed wiring board according to [25] or the semiconductor chip package according to [26] or [27].

### EFFECT OF THE INVENTION

According to the present invention, it is possible to provide a polyester resin that achieves a cured product exhibiting excellent dielectric properties and also favorable mechanical properties in combination with the cross-linkable resin.

### EMBODIMENT FOR CARRYING OUT THE INVENTION

### <Description of Terms>

In the present specification, the term "optionally having a substituent" with respect to a compound or group means both a case where a hydrogen atom of the compound or group is not substituted with a substituent and a case where a part or all of the hydrogen atoms of the compound or group are substituted with a substituent.

In the present specification, unless otherwise specified, the term "substituent" means a halogen atom, an alkyl group, an alkenyl group, an alkynyl group, an alkapolyenyl group, a cycloalkyl group, a cycloalkenyl group, an alkoxy group, a cycloalkyloxy group, an aryl group, an aryloxy group, an arylalkyl group, an arylalkoxy group, a monovalent heterocyclic group, an alkylidene group, an amino group, a silyl group, an acyl group, an acyloxy group, a carboxy group, a sulfo group, a cyano group, a nitro group, a hydroxy group, a mercapto group, and an oxo group. Note that groups that contain only carbon and hydrogen atoms, such as an alkyl group, an alkenyl group, an alkynyl group, an alkapolyenyl group, a cycloalkyl group, a cycloalkenyl group, an aryl group, an arylalkyl group, and an alkylidene group are also collectively referred to as a "hydrocarbon group". Furthermore, aliphatic hydrocarbon groups that have unsaturated bonds, such as an alkenyl group, an alkynyl group, an alkapolyenyl group, and a cycloalkenyl group are also collectively referred to as an "unsaturated aliphatic hydrocarbon group".

Examples of the halogen atom used as the substituent may include a fluorine atom, a chlorine atom, a bromine atom, and an iodine atom.

An alkyl group used as the substituent may be either linear or branched. The number of carbon atoms in the alkyl group is preferably 1 to 20, more preferably 1 to 14, further preferably 1 to 12, still further preferably 1 to 6, and particularly preferably 1 to 3. Examples of the alkyl group may include a methyl group, an ethyl group, a propyl group, an isopropyl group, a butyl group, a sec-butyl group, an isobutyl group, a tert-butyl group, a pentyl group, a hexyl group, a heptyl group, an octyl group, a nonyl group, and a decyl group.

An alkenyl group used as the substituent may be either linear or branched. The number of carbon atoms in the alkenyl group is preferably 2 to 20, more preferably 2 to 14, further preferably 2 to 12, still further preferably 2 to 6, and particularly preferably 2 or 3. Examples of the alkenyl group may include a vinyl group, an allyl group, a 1-propenyl group, a butenyl group, a sec-butenyl group, an isobutenyl group, a tert-butenyl group, a pentenyl group, a hexenyl group, a heptenyl group, an octenyl group, a nonenyl group, and a decenyl group.

An alkynyl group used as the substituent may be either linear or branched. The number of carbon atoms in the alkynyl group is preferably 2 to 20, more preferably 2 to 14, further preferably 2 to 12, still further preferably 2 to 6, and particularly preferably 2 or 3. Examples of the alkynyl group may include an ethynyl group, a propynyl group, a butynyl group, a sec-butynyl group, an isobutynyl group, a tert-butynyl group, a pentynyl group, a hexynyl group, a heptynyl group, an octynyl group, a nonynyl group, and a decynyl group.

An alkapolyenyl group used as the substituent may be either linear or branched, and the number of double bonds therein is preferably 2 to 10, more preferably 2 to 6, further preferably 2 to 4, and still further preferably 2. The number of carbon atoms in the alkapolyenyl group is preferably 3 to 20, more preferably 3 to 14, further preferably 3 to 12, and still further preferably 3 to 6.

The number of carbon atoms in the cycloalkyl group used as the substituent is preferably 3 to 20, more preferably 3 to 12, and further preferably 3 to 6. Examples of the cycloalkyl group may include a cyclopropyl group, a cyclobutyl group, a cyclopentyl group, and a cyclohexyl group.

The number of carbon atoms in the cycloalkenyl group used as the substituent is preferably 3 to 20, more preferably 3 to 12, and further preferably 3 to 6. Examples of the cycloalkenyl group may include a cyclopropenyl group, a cyclobutenyl group, a cyclopentenyl group, and a cyclohexenyl group.

An alkoxy group used as the substituent may be either linear or branched. The number of carbon atoms in the alkoxy group is preferably 1 to 20, more preferably 1 to 12, and further preferably 1 to 6. Examples of the alkoxy group may include a methoxy group, an ethoxy group, a propyloxy group, an isopropyloxy group, a butoxy group, a sec-butoxy group, an isobutoxy group, a tert-butoxy group, a pentyloxy group, a hexyloxy group, a heptyloxy group, an octyloxy group, a nonyloxy group, and a decyloxy group.

The number of carbon atoms in the cycloalkyloxy group used as the substituent is preferably 3 to 20, more preferably 3 to 12, and further preferably 3 to 6. Examples of the cycloalkyloxy group may include a cyclopropyloxy group, a cyclobutyloxy group, a cyclopentyloxy group, and a cyclohexyloxy group.

An aryl group used as the substituent is a group obtained by removing one hydrogen atom on an aromatic ring from an aromatic hydrocarbon. The number of carbon atoms in the aryl group used as the substituent is preferably 6 to 24, more preferably 6 to 18, further preferably 6 to 14, and still further preferably 6 to 10. Examples of the aryl group may include a phenyl group, a naphthyl group, and an anthracenyl group.

The number of carbon atoms in the aryloxy group used as the substituent is preferably 6 to 24, more preferably 6 to 18, further preferably 6 to 14, and still further preferably 6 to 10. Examples of the aryloxy group used as the substituent may include a phenoxy group, a 1-naphthyloxy group, and a 2-naphthyloxy group.

The number of carbon atoms in the arylalkyl group used as the substituent is preferably 7 to 25, more preferably 7 to 19, further preferably 7 to 15, and still further preferably 7 to 11. Examples of the arylalkyl group may include a phenyl-C₁ to C₁₂ alkyl group, a naphthyl-C₁ to C₁₂ alkyl group, and an anthracenyl-C₁ to C₁₂ alkyl group.

The number of carbon atoms in the arylalkoxy group used as the substituent is preferably 7 to 25, more preferably 7 to 19, further preferably 7 to 15, and still further preferably 7 to 11. Examples of the arylalkoxy group may include a phenyl-C₁ to C₁₂ alkoxy group and a naphthyl-C₁ to C₁₂ alkoxy group.

A monovalent heterocyclic group used as the substituent refers to a group obtained by removing one hydrogen atom from a heterocyclic ring of a heterocyclic compound. The number of carbon atoms in the monovalent heterocyclic group is preferably 3 to 21, more preferably 3 to 15, and further preferably 3 to 9. The monovalent heterocyclic group also includes a monovalent aromatic heterocyclic group (heteroaryl group). Examples of the monovalent heterocyclic ring may include a thienyl group, a pyrrolyl group, a furanyl group, a furyl group, a pyridyl group, a pyridazinyl group, a pyrimidyl group, a pyrazinyl group, a triazinyl group, a pyrrolidyl group, a piperidyl group, a quinolyl group, and an isoquinolyl group.

An alkylidene group used as the substituent refers to a group in which two hydrogen atoms are removed from the same carbon atom of an alkane. The number of carbon atoms in the alkylidene group is preferably 1 to 20, more preferably 1 to 14, further preferably 1 to 12, still further preferably 1 to 6, and particularly preferably 1 to 3. Examples of the alkylidene group may include a methylidene group, an ethylidene group, a propylidene group, an isopropylidene group, a butylidene group, a sec-butylidene group, an isobutylidene group, a tert-butylidene group, a pentylidene group, a hexylidene group, a heptylidene group, an octylidene group, a nonylidene group, and a decylidene group.

An acyl group used as the substituent refers to a group represented by the formula: -C(=O)-R (in the formula, R is an alkyl group or an aryl group). The alkyl group represented by R may be either linear or branched. Examples of the aryl group represented by R may include a phenyl group, a naphthyl group, and an anthracenyl group. The number of carbon atoms in the acyl group is preferably 2 to 20, more preferably 2 to 13, and further preferably 2 to 7. Examples of the acyl group may include an acetyl group, a propionyl group, a butyryl group, an isobutyryl group, a pivaloyl group, and a benzoyl group.

An acyloxy group used as the substituent refers to a group represented by the formula: -O-C(=O)-R (in the formula, R is an alkyl group or an aryl group). The alkyl group represented by R may be either linear or branched. Examples of the aryl group represented by R may include a phenyl group, a naphthyl group, and an anthracenyl group. The number of carbon atoms in the acyloxy group is preferably 2 to 20, more preferably 2 to 13, and further preferably 2 to 7. Examples of the acyloxy group may include an acetoxy group, a propionyloxy group, a butyryloxy group, an isobutyryloxy group, a pivaloyloxy group, and a benzoyloxy group.

The above-mentioned substituent may further have a substituent (hereinafter, sometimes referred to as a "secondary substituent"). As the secondary substituent, the same substituents as those described above may be used, unless otherwise specified.

In the present specification, the term "organic group" refers to a group containing at least carbon atoms as the skeletal atoms, and may be either linear, branched or cyclic. In the present specification, the number of skeletal atoms in the organic group is preferably 1 to 3,000, more preferably 1 to 1,000, further preferably 1 to 100, still further preferably 1 to 50, and particularly preferably 1 to 30 or 1 to 20, unless otherwise specified. Examples of the organic group may include groups composed of one or more skeletal atoms selected from a carbon atom, an oxygen atom, a nitrogen atom, and a sulfur atom (including at least a carbon atom).

In the present specification, the term "hydrocarbon group" refers to a group obtained by removing one or more hydrogen atoms from a hydrocarbon compound. Specifically, a monovalent hydrocarbon group refers to a group obtained by removing one hydrogen atom from a hydrocarbon compound, and a divalent hydrocarbon group refers to a group obtained by removing two hydrogen atoms from a hydrocarbon compound. Examples of the hydrocarbon group may include a group containing only carbon atoms and hydrogen atoms among aliphatic groups and aromatic groups described later. In the present specification, an aliphatic group containing only carbon atoms and hydrogen atoms is also referred to as an "aliphatic hydrocarbon group", and an aromatic group containing only carbon atoms and hydrogens atom is also referred to as an "aromatic hydrocarbon group". Examples of the divalent hydrocarbon group may include an alkylene group, a cycloalkylene group, an alkenylene group, a cycloalkenylene group, an alkapolyenylene group, and an arylene group.

In the present specification, the term "aliphatic group" refers to a group obtained by removing one or more hydrogen atoms bonded to the aliphatic carbon of an aliphatic compound. Specifically, a monovalent aliphatic group refers to a group obtained by removing one hydrogen atom bonded to the aliphatic carbon of an aliphatic compound, and a divalent aliphatic group refers to a group obtained by removing two hydrogen atoms bonded to the aliphatic carbon of an aliphatic compound. Examples of the divalent aliphatic group may include an alkylene group optionally having a substituent, a cycloalkylene group optionally having a substituent, an alkenylene group optionally having a substituent, a cycloalkenylene group optionally having a substituent, and an alkapolyenylene group (the number of double bonds is preferably 2 to 10, more preferably 2 to 6, further preferably 2 to 4, and still further preferably 2) optionally having a substituent. In the present specification, the number of carbon atoms in the aliphatic group is preferably 1 or more, more preferably 2 or more, further preferably 3 or more, 4 or more, 5 or more, or 6 or more, and preferably 50 or less, more preferably 40 or less, further preferably 30 or less, 20 or less, 18 or less, 16 or less, 14 or less, or 12 or less, unless otherwise specified. The number of carbon atoms does not include the number of carbon atoms in the substituent.

In the present specification, the term "aromatic group" refers to a group obtained by removing one or more hydrogen atoms from the aromatic ring of an aromatic compound. Specifically, a monovalent aromatic group refers to a group obtained by removing one hydrogen atom from the aromatic ring of an aromatic compound, and a divalent aromatic group refers to a group obtained by removing two hydrogen atoms from the aromatic ring of an aromatic compound. Examples of the monovalent aromatic group may include an aryl group optionally having a substituent and a heteroaryl group optionally having a substituent. Examples of the divalent aromatic group may include an arylene group optionally having a substituent and a heteroarylene group optionally having a substituent. In the present specification, unless otherwise specified, the number of carbon atoms in the aromatic group is preferably 3 or more, more preferably 4 or more, 5 or more, and further preferably 6 or more, and the upper limit thereof is preferably 24 or less, more preferably 18 or less, or 14 or less, and further preferably 10 or less. The number of carbon atoms does not include the number of carbon atoms in the substituent.

In the present specification, the term "aromatic ring" means a ring according to the Huckel's rule in which the number of electrons contained in the π-electron system on the ring is 4p+2 (p is a natural number), and includes a monocyclic aromatic ring and a condensed polyaromatic ring in which two or more monocyclic aromatic rings are condensed. The aromatic ring may be an aromatic carbocyclic ring having only carbon atoms as ring member atoms, or an aromatic heterocyclic ring having heteroatoms such as an oxygen atom, a nitrogen atom, and a sulfur atom in addition to carbon atoms as ring member atoms. In the present specification, unless otherwise specified, the number of carbon atoms in the aromatic ring is preferably 3 or more, more preferably 4 or more or 5 or more, and further preferably 6 or more, and the upper limit thereof is preferably 24 or less, more preferably 18 or less or 14 or less, and further preferably 10 or less. The number of carbon atoms does not include the number of carbon atoms in the substituent. Examples of the aromatic ring may include: monocyclic aromatic rings such as a benzene ring, a furan ring, a thiophene ring, a pyrrole ring, a pyrazole ring, an oxazole ring, an isoxazole ring, a thiazole ring, an imidazole ring, a pyridine ring, a pyridazine ring, a pyrimidine ring, and a pyrazine ring; and condensed polycyclic aromatic rings obtained by condensing two or more monocyclic aromatic rings such as a naphthalene ring, an anthracene ring, a phenanthrene ring, a benzofuran ring, an isobenzofuran ring, an indole ring, an isoindole ring, a benzothiophene ring, a benzoimidazole ring, an indazole ring, a benzoxazole ring, a benzoisoxazole ring, a benzothiazole ring, a quinoline ring, an isoquinoline ring, a quinoxaline ring, an acridine ring, a quinazoline ring, a sinoline ring, and a phthalazine ring. In the present specification, carbon atoms constituting an aromatic ring are referred to as "aromatic carbons".

Hereinafter, the present invention will be described in detail with reference to preferred embodiments thereof. However, the present invention is not limited to the embodiments and examples described below. The present invention may be optionally modified for implementation without departing from the scope of claims of the present invention and the scope of equivalents thereof.

### [Polyester resin]

The polyester resin of the present invention contains a structural unit represented by the following general formula (1) (hereinafter, also referred to as "structural unit (1)"), and has an aromatic oxycarbonyl group at its terminal: 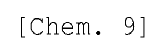 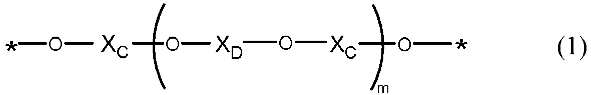 (in the formula,
X_{C}s each independently represent a divalent organic group containing at least one aromatic ring,
X_{D}s each independently represent a divalent organic group,
m is an average value of the number of repetitions, and is a number satisfying 0 < m ≤ 10, and
* indicates a bond.)

The polyester resin of the present invention contains the structural unit (1) which is an oligomer unit that includes X_{C} and X_{D}, and thus can achieve a cured product exhibiting excellent dielectric properties and also favorable mechanical properties in combination with the cross-linkable resin.

X_{C} and X_{D} constituting the structural unit (1) will be described later, and from the viewpoint of achieving a cured product exhibiting excellent dielectric properties and also favorable mechanical properties in combination with the cross-linkable resin, the lower limit of m in the general formula (1) is more than 0, preferably 0.1 or more, more preferably 0.2 or more, 0.3 or more, or 0.4 or more, further preferably 0.5 or more, 0.6 or more, or 0.7 or more. The upper limit of m is preferably 8 or less, 6 or less, 5 or less, 4 or less, or 3 or less. Therefore, in a preferred embodiment, m in the general formula (1) is a number satisfying 0 < m ≤ 3.

### - Unit X_{C} -

In the structural unit (1), X_{C}s each independently represent a divalent organic group having at least one aromatic ring.

As described above, the aromatic ring contained in the divalent organic group represented by X_{C} may be either a monocyclic aromatic ring or a condensed polycyclic aromatic ring in which two or more monocyclic aromatic rings are condensed. The aromatic ring may be either an aromatic carbocyclic ring or an aromatic heterocyclic ring.

From the viewpoint of achieving a cured product exhibiting even more excellent dielectric properties in combination with the cross-linkable resin, X_{C} preferably contains two or more monocyclic aromatic rings or at least one condensed polycyclic aromatic ring as the aromatic ring. Monocyclic aromatic rings and condensed polycyclic aromatic rings are as described above. Thus, in a preferred embodiment, X_{C}s each independently represent a divalent organic group containing two or more monocyclic aromatic rings or a divalent organic group containing at least one condensed polycyclic aromatic ring.

From the viewpoint of achieving a cured product exhibiting even more excellent dielectric properties in combination with the cross-linkable resin, the aromatic ring in X_{C} is preferably an aromatic carbocyclic ring. The number of carbon atoms in the aromatic carbocyclic ring is preferably 6 to 14, and more preferably 6 to 10. Thus, in a preferred embodiment, the aromatic ring contained in the divalent organic group represented by X_{C} is an aromatic carbocycle ring of 6 to 14 carbon atoms.

In particular, from the viewpoint of achieving a cured product exhibiting even more excellent dielectric properties, X_{C} represents a divalent organic group containing two or more monocyclic aromatic carbocyclic rings or a divalent organic group containing at least one condensed polycyclic aromatic carbocyclic ring. Here, the number of carbon atoms per monocyclic aromatic carbocyclic ring is as described above, and is preferably 6 (i.e., a benzene ring). The number of carbon atoms per condensed polycyclic aromatic carbocyclic ring is as described above, and is preferably 10 to 14 (e.g., a naphthalene ring, an anthracene ring), more preferably 10.

The aromatic ring that is contained in the divalent organic group represented by X_{C} may have a substituent. Such substituents are as described above, and among these, one or more types selected from a hydrocarbon group and an alkoxy group are preferable from the viewpoint of achieving a cured product exhibiting even more excellent dielectric properties in combination with the cross-linkable resin. The hydrocarbon group or alkoxy group used as the substituent is as described above. Among these, one or more types selected from a hydrocarbon group of 1 to 10 carbon atoms and an alkoxy group of 1 to 10 carbon atoms are more preferable, and one or more types selected from an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, and an alkoxy group of 1 to 6 carbon atoms are more preferable.

When the aromatic ring in Xc has an unsaturated aliphatic hydrocarbon group as a substituent, the unsaturated aliphatic hydrocarbon group is preferably an alkenyl group or an alkynyl group, more preferably an alkenyl group, and further preferably an allyl group.

The divalent organic group represented by X_{C} is not particularly limited as long as it contains at least one aromatic ring described above. As described above, the divalent organic group is a group containing at least carbon atoms as skeletal atoms. The divalent organic group is preferably a divalent group formed of one or more skeletal atoms (preferably 1 to 100, 1 to 50, and 1 to 30 skeletal atoms) selected from a carbon atom, an oxygen atom, a nitrogen atom, and a sulfur atom. Among these, the divalent organic group represented by Xc particularly preferably contains only carbon atoms, as a minimum, as the skeletal atoms from the viewpoint of achieving a cured product exhibiting even more excellent dielectric properties in combination with the cross-linkable resin.

Accordingly, in one particularly preferred embodiment, X_{C} indicates a divalent group that contains at least two or more monocyclic aromatic carbocyclic rings optionally having a substituent and that includes only carbon atoms as the skeletal atoms. Alternatively, X_{C} indicates a divalent group that contains at least one condensed polycyclic aromatic carbocyclic ring optionally having a substituent and that contains only carbon atoms as the skeletal atoms. Here, the substituent is one or more types selected from an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, and an alkoxy group of 1 to 6 carbon atoms. Preferred values and ranges for the number of carbon atoms per monocyclic aromatic carbocyclic ring or condensed polycyclic aromatic carbocyclic ring are as described above. The preferred range of the number of skeletal atoms is as described above. Within this range, 10 to 50 or 10 to 30 is preferable.

From the viewpoint of achieving a cured product exhibiting excellent dielectric properties and also favorable mechanical properties in combination with the cross-linkable resin, it is preferable that the oxygen atom bonded to X_{C} in the structural unit (1) is bonded to an aromatic carbon of X_{C}, that is, a carbon atom constituting the above-mentioned aromatic ring.

In one embodiment, X_{C} is represented by the following formula (C-1), formula (C-2), or formula (C-3): 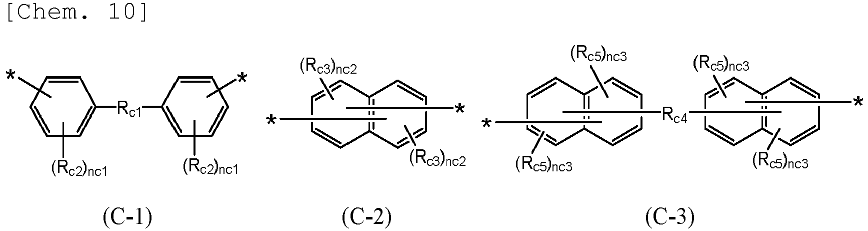 (in the formulas,
R_{c1}s and R_{c4}s each independently represent a single bond, or a divalent linking group selected from the group consisting of a divalent hydrocarbon group of 1 to 10 carbon atoms optionally having a substituent, an oxygen atom, a sulfonyl group, a carbonyl group, a carbonate group, and a combination thereof,
R_{c2}s, R_{c3}s, and R_{c5}s each independently represent a substituent,
nc1, nc2, and nc3 each independently represent a number of 0 to 4, and
* indicates a bond.)

In the formula (C-1), two benzene rings are shown. These two benzene rings correspond to the "aromatic ring" described above for Xc. That is, Xc represented by the formula (C-1) is a divalent organic group that contains at least two benzene rings. Preferable examples of the substituent R_{c2} are also as described for the "aromatic ring" in Xc. Among these, one or more types selected from an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, and an alkoxy group of 1 to 6 carbon atoms are preferable.

In the formula (C-1), nc1's each independently represent a number of 0 to 4, preferably 0 to 3, more preferably 0 to 2, and further preferably 0 or 1.

In the formula (C-1), R_{c1} represents a single bond or a divalent linking group selected from the group consisting of a divalent hydrocarbon group of 1 to 10 carbon atoms optionally having a substituent, an oxygen atom, a sulfonyl group, a carbonyl group, a carbonate group, and a combination thereof. The number of carbon atoms in the divalent linking group represented by R_{c1} is preferably 1 to 30, more preferably 1 to 20 or 1 to 15.

Examples of the divalent hydrocarbon group in R_{c1} may include a divalent aliphatic hydrocarbon group and a divalent aromatic hydrocarbon group, for example, such as an alkylene group, a cycloalkylene group, an alkenylene group, a cycloalkenylene group, an alkapolyenylene group (the number of double bonds is preferably 2 to 10, more preferably 2 to 6, further preferably 2 to 4, and still further preferably 2), and an arylene group. An alkylene group, a cycloalkylene group, an alkenylene group, a cycloalkenylene group, and an arylene group are preferable, and an alkylene group, a cycloalkylene group, and an arylene group are more preferable.

The alkylene group in R_{c1} may be either linear or branched, and the number of carbon atoms therein is more preferably 1 to 6, and further preferably 1 to 4 or 1 to 3. The number of carbon atoms does not include the number of carbon atoms in the substituent. Examples of the alkylene group may include a methylene group, an ethylene group, a propylene group, a butylene group, a pentylene group, and a hexylene group.

The number of carbon atoms in the cycloalkylene group in R_{c1} is more preferably 3 to 10, 4 to 10, or 6 to 10. The number of carbon atoms does not include the number of carbon atoms in the substituent. Examples of the cycloalkylene group may include a cyclopropylene group, a cyclobutylene group, a cyclopentylene group, a cyclohexylene group, a decahydronaphthalene group, a norbornanylene group, a dicyclopentanylene group, and an adamantanylene group.

The alkenylene group in R_{c1} may be either linear or branched, and the number of carbon atoms thereof is more preferably 2 to 6, and further preferably 2 to 4. The number of carbon atoms does not include the number of carbon atoms in the substituent. Examples of the alkenylene group may include an ethenylene group, a propenylene group, a butenylene group, a pentenylene group, and a hexenylene group.

The number of carbon atoms in the cycloalkenylene group in R_{c1} is more preferably 3 to 10, 4 to 10, or 6 to 10. The number of carbon atoms does not include the number of carbon atoms in the substituent. Examples of the cycloalkenylene group may include a cyclopropenylene group, a cyclobutenylene group, a cyclopentenylene group, a cyclohexenylene group, and a norbornenylene group.

The number of carbon atoms in the arylene group in R_{c1} is preferably 6 to 10. The number of carbon atoms does not include the number of carbon atoms in the substituent. Examples of the arylene group may include a phenylene group, a naphthylene group, and an indanediyl group.

From the viewpoint of achieving a cured product exhibiting even more excellent dielectric properties in combination with the cross-linkable resin, the divalent linking group represented by R_{c1} is preferably a divalent hydrocarbon group of 1 to 10 carbon atoms optionally having a substituent or a divalent group composed of a combination thereof. Among these, the divalent linking group is preferably an alkylene group of 1 to 6 carbon atoms optionally having a substituent, a cycloalkylene group of 6 to 10 carbon atoms optionally having a substituent, an alkenylene group of 2 to 6 carbon atoms optionally having a substituent, a cycloalkenylene group of 6 to 10 carbon atoms optionally having a substituent, an arylene group of 6 to 10 carbon atoms optionally having a substituent, or a divalent group composed of a combination thereof. It is more preferable that the divalent linking group is an alkylene group of 1 to 6 carbon atoms optionally having a substituent, a cycloalkylene group of 6 to 10 carbon atoms optionally having a substituent, an arylene group of 6 to 10 carbon atoms optionally having a substituent, or a divalent group composed of a combination thereof. Preferable examples of the divalent group composed of a combination of hydrocarbon groups may include a C₁ to C₆ alkylene-C₆ to C₁₀ arylene-C₁ to C₆ alkylene group and a C₁ to C₆ alkylene-C₆ to C₁₀ arylene-C₆ to C₁₀ arylene-C₁ to C₆ alkylene group. In the divalent group composed of the combination thereof, the preferred range of the number of carbon atoms in the constituent alkylene group or arylene group and the fact that the divalent group optionally has a substituent are as described above.

The substituents that are optionally contained in the divalent hydrocarbon group in R_{c1} are as described above. Among these, the substituent is preferably one or more types selected from an alkyl group and an aryl group, and more preferably one or more types selected from an alkyl group of 1 to 6 carbon atoms and an aryl group of 6 to 10 carbon atoms.

Examples of X_{C} represented by the formula (C-1) that is particularly suitable from the viewpoint of achieving a cured product exhibiting even more excellent dielectric properties in combination with the cross-linkable polymer are shown below.

In one preferred embodiment, in the formula (C-1),
R_{c1} represents a single bond or an alkylene group of 1 to 6 carbon atoms optionally having a substituent, a cycloalkylene group of 6 to 10 carbon atoms optionally having a substituent, an arylene group of 6 to 10 carbon atoms optionally having a substituent, or a divalent group composed of a combination thereof,
R_{c2}s each independently represent an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, or an alkoxy group of 1 to 6 carbon atoms, and
nc1's are each independently 0 or 1.

In one more preferred embodiment, in the formula (C-1),
R_{c1} represents a single bond, an alkylene group of 1 to 3 carbon atoms optionally having a substituent, a cycloalkylene group of 6 to 10 carbon atoms optionally having a substituent, a (C₁ to C₃ alkylene-C₆ to C₁₀ arylene-C₁ to C₃ alkylene) group optionally having a substituent, or a (C₁ to C₃ alkylene-C₆ to C₁₀ arylene-C₆ to C₁₀ arylene-C₁ to C₃ alkylene) group optionally having a substituent,
R_{c2}s each independently represent an alkyl group of 1 to 3 carbon atoms, an aryl group of 6 to 10 carbon atoms, an arylalkyl group of 7 to 10 carbon atoms, an allyl group, or an alkoxy group of 1 to 3 carbon atoms, and
nc1's are each independently 0 or 1.

In the formula (C-2), one naphthalene ring is shown. The one naphthalene ring corresponds to the "aromatic ring" described above for X_{C}. That is, X_{C} represented by the formula (C-2) is a divalent organic group that contains at least one naphthalene ring. Preferable examples of the substituent R_{c3} are also as described for the "aromatic ring" in X_{C}. Among these, one or more types selected from an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, and an alkoxy group of 1 to 6 carbon atoms are preferable.

In the formula (C-2), nc2's each independently represent a number of 0 to 4, preferably 0 to 3, more preferably 0 to 2, and further preferably 0 or 1.

Examples of X_{C} represented by the formula (C-2) that are particularly preferable from the viewpoint of achieving a cured product exhibiting even more excellent dielectric properties in combination with the cross-linkable resin are shown below.

In one preferred embodiment, in the formula (C-2),
R_{c3}'s each independently represent an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, or an alkoxy group of 1 to 6 carbon atoms, and
nc2's are each independently 0 or 1.

In one more preferred embodiment, in the formula (C-2),
R_{c3}'s each independently represent an alkyl group of 1 to 3 carbon atoms, an aryl group of 6 to 10 carbon atoms, an arylalkyl group of 7 to 10 carbon atoms, an allyl group, or an alkoxy group of 1 to 3 carbon atoms, and
nc2's are each independently 0 or 1.

In the formula (C-3), two naphthalene rings are shown. These two naphthalene rings correspond to the "aromatic rings" described above for X_{C}. That is, X_{C} represented by the formula (C-3) is a divalent organic group that contains at least two naphthalene rings. Preferable examples of the substituent R_{c5} are also as described for the "aromatic ring" in X_{C}. Among these, one or more types selected from an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, and an alkoxy group of 1 to 6 carbon atoms are preferable.

In the formula (C-3), nc3's are independently represent a number of 0 to 4, preferably 0 to 3, more preferably 0 to 2, and further preferably 0 or 1.

In the formula (C-3), R_{c4} represents a single bond or a divalent linking group selected from the group consisting of a divalent hydrocarbon group of 1 to 10 carbon atoms optionally having a substituent, an oxygen atom, a sulfonyl group, a carbonyl group, a carbonate group, and a combination thereof. The number of carbon atoms in the divalent linking group represented by R_{c4} is preferably 1 to 20, and more preferably 1 to 10 or 1 to 6.

The divalent hydrocarbon group in R_{c4} is the same as the divalent hydrocarbon group in R_{c1} including preferable examples thereof. Among these, an alkylene group of 1 to 6 carbon atoms optionally having a substituent or a cycloalkylene group of 6 to 10 carbon atoms optionally having a substituent is preferable. Preferable examples of the substituent are also the same as those of the divalent hydrocarbon group in R_{C1}.

Examples of Xc represented by the formula (C-3) that are particularly preferred from the viewpoint of achieving a cured product exhibiting even more excellent dielectric properties in combination with the cross-linkable resin are shown below.

In one preferred embodiment, in the formula (C-3),
R_{c4} represents a single bond, an alkylene group of 1 to 6 carbon atoms optionally having a substituent, or a cycloalkylene group of 6 to 10 carbon atoms optionally having a substituent,
R_{c5}s each independently represent an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, or an alkoxy group of 1 to 6 carbon atoms, and
nc3's are each independently 0 or 1.

In one more preferred embodiment, in the formula (C-3),
R_{c4} represents a single bond or an alkylene group of 1 to 3 carbon atoms optionally having a substituent,
R_{c5}s each independently represent an alkyl group of 1 to 3 carbon atoms, an aryl group of 6 to 10 carbon atoms, an arylalkyl group of 7 to 10 carbon atoms, an allyl group, or an alkoxy group of 1 to 3 carbon atoms, and
nc3's are each independently 0 or 1.

In one preferred embodiment, specific examples of Xc may include divalent groups represented by the formulas (c-1) to (c-12) described below. The divalent groups represented by the formulas (c-1) to (c-8) correspond to Xc represented by the above-mentioned formula (C-1), the divalent groups represented by the formulas (c-9) and (c-10) correspond to Xc represented by the above-mentioned formula (C-2), and the divalent groups represented by the formulas (c-11) and (c-12) correspond to Xc represented by the above-mentioned formula (C-3). 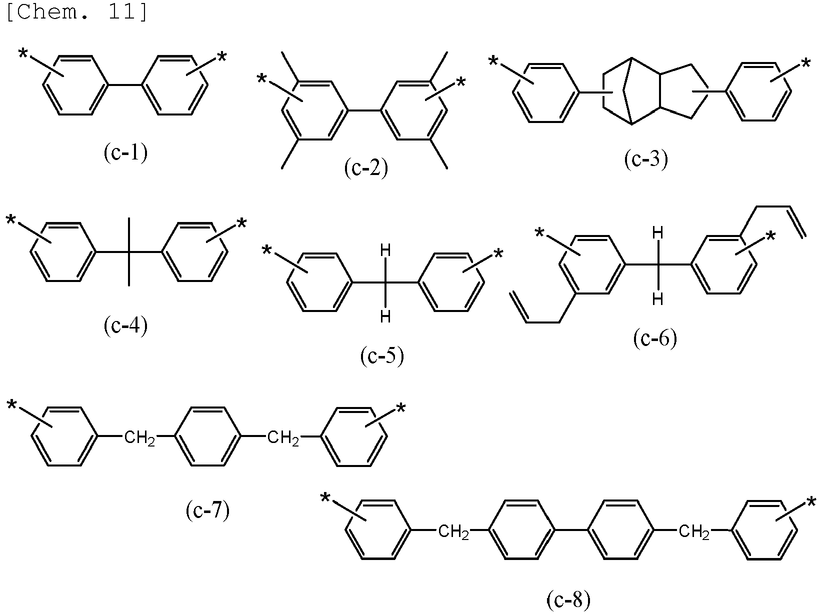 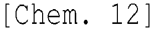 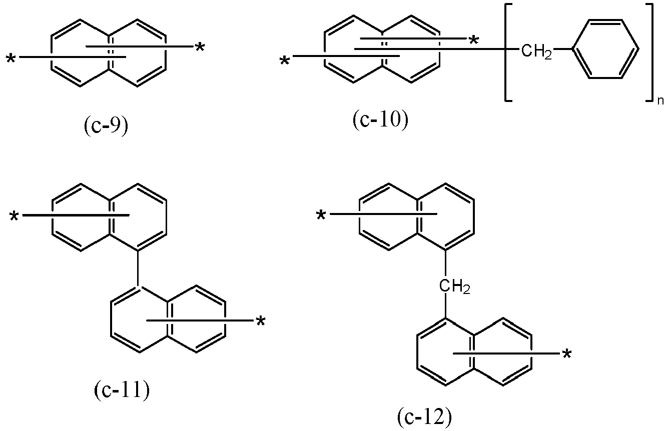 (in the formula, n is 1 or 2 and * represents a bond.)

### - Unit X_{D} -

In the structural unit (1), X_{D}s each independently represent a divalent organic group.

As described above, the polyester resin of the present invention contains the structural unit (1), which is an oligomer unit containing X_{D}, and thus can achieve a cured product having excellent dielectric properties and also favorable mechanical properties in combination with the cross-linkable resin.

As described above, the divalent organic group represented by X_{D} is a group containing carbon atoms, as a minimum, as the skeletal atoms. It is preferable that the skeleton atom at its terminal is an aliphatic carbon from the viewpoint of being able to further benefit from the advantageous effects of the present invention. Preferable examples of the divalent organic group represented by X_{D} include divalent groups that are formed of one or more skeletal atoms (preferably 1 to 100, 1 to 50, and 1 to 30 skeletal atoms) selected from a carbon atom, an oxygen atom, a nitrogen atom, and a sulfur atom and whose terminal skeletal atom is an aliphatic carbon. Among these, the divalent organic group represented by X_{D} particularly preferably contains only carbon atoms as the skeletal atoms from the viewpoint of achieving a cured product exhibiting even more excellent dielectric properties and also exhibiting even more favorable mechanical properties in combination with the cross-linkable resin. Accordingly, in one preferred embodiment, the divalent organic group represented by X_{D} is a divalent group containing only carbon atoms as the skeletal atoms and the terminal formed of an aliphatic carbon.

In one embodiment, X_{D} is
(i) a divalent aliphatic hydrocarbon group, or
(ii) a divalent organic group represented by the following formula (D-1) or (D-2). 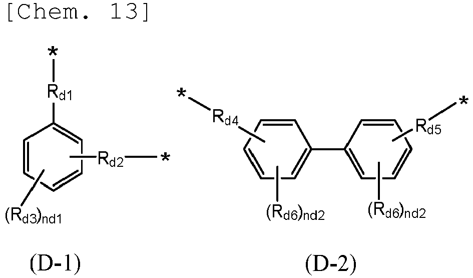
(in the formula,
R_{d1}, R_{d2}, R_{d4} and R_{d5} each independently represent a divalent aliphatic hydrocarbon group,
R_{d3} and R_{d6} each independently represent a substituent,
nd1 and nd2 each independently represent a number of 0 to 4, and
* represents a bond.)

When X_{D} is (i) a divalent aliphatic hydrocarbon group, a cured product that exhibits excellent dielectric properties and also exhibits even more favorable mechanical properties can be achieved. The divalent aliphatic hydrocarbon group is preferably an alkylene group, a cycloalkylene group, an alkenylene group or a cycloalkenylene group, more preferably an alkylene group or an alkenylene group, and further preferably an alkylene group, from the viewpoint of achieving a cured product exhibiting even better mechanical properties.

The alkylene group in X_{D} may be either linear or branched, and is preferably linear from the viewpoint of achieving a cured product exhibiting even better mechanical properties. The number of carbon atoms in the alkylene group is more preferably 1 to 12, further preferably 2 to 12, and still further preferably 4 to 12 or 4 to 10. Examples of the alkylene group may include a methylene group, an ethylene group, a propylene group, a butylene group, a pentylene group, and a hexylene group.

The number of carbon atoms in the cycloalkylene group in X_{D} is more preferably 3 to 10, 4 to 10, or 6 to 10. Examples of the cycloalkylene group may include a cyclopropylene group, a cyclobutylene group, a cyclopentylene group, a cyclohexylene group, a decahydronaphthalene group, a norbornanylene group, a dicyclopentanylene group, and an adamantanylene group.

The alkenylene group in X_{D} may be either linear or branched, and is preferably linear from the viewpoint of achieving a cured product exhibiting even better mechanical properties. The number of carbon atoms in the alkenylene group is more preferably 2 to 12, further preferably 4 to 12 or 4 to 10. Examples of the alkenylene group may include an ethenylene group, a propenylene group, a butenylene group, a pentenylene group, and a hexenylene group.

The number of carbon atoms in the cycloalkenylene group in X_{D} is more preferably 3 to 10, 4 to 10, or 6 to 10. Examples of the cycloalkenylene group may include a cyclopropenylene group, a cyclobutenylene group, a cyclopentenylene group, a cyclohexenylene group, and a norbornenylene group.

When X_{D} is (i) a divalent aliphatic hydrocarbon group, specific examples of X_{D} may include divalent groups represented by the formulas (d1-1) to (d1-5) described below. 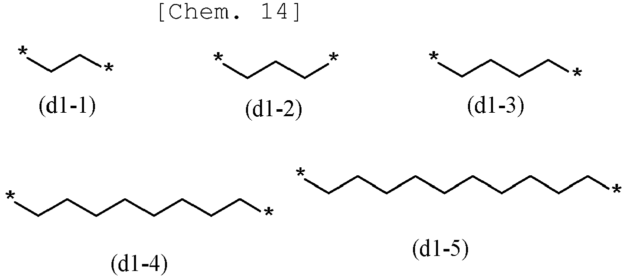 (in the formula, * represents a bond.)

When X_{D} is (ii) a divalent organic group represented by the formula (D-1) or the formula (D-2), a cured product that exhibits even more excellent dielectric properties and also exhibits favorable mechanical properties can be achieved.

In the formula (D-1), R_{d1} and R_{d2} each independently represent a divalent aliphatic hydrocarbon group. The divalent aliphatic hydrocarbon group is preferably an alkylene group, a cycloalkylene group, an alkenylene group or a cycloalkenylene group, more preferably an alkylene group or an alkenylene group, and further preferably an alkylene group.

The alkylene group in R_{d1} and R_{d2} may be either linear or branched, and is preferably linear from the viewpoint of further benefiting from the advantageous effects of the present invention. The number of carbon atoms in the alkylene group is more preferably 1 to 12, further preferably 1 to 6, and still further preferably 1 to 4 or 1 to 3. Examples of the alkylene groups may include a methylene group, an ethylene group, a propylene group, a butylene group, a pentylene group, and a hexylene group.

The number of carbon atoms in the cycloalkylene group in R_{d1} and R_{d2} is more preferably 3 to 10, 4 to 10, or 6 to 10. Examples of the cycloalkylene group may include a cyclopropylene group, a cyclobutylene group, a cyclopentylene group, a cyclohexylene group, a decahydronaphthalene group, a norbornanylene group, a dicyclopentanylene group, and an adamantanylene group.

The alkenylene group in R_{d1} and R_{d2} may be either linear or branched, and is preferably linear from the viewpoint of further benefiting from the advantageous effects of the present invention. The number of carbon atoms in the alkenylene group is more preferably 2 to 12, further preferably 2 to 6, and still further preferably 2 to 4, or 2 or 3. Examples of the alkenylene group may include an ethenylene group, a propenylene group, a butenylene group, a pentenylene group, and a hexenylene group.

The number of carbon atoms in the cycloalkenylene group in R_{d1} and R_{d2} is more preferably 3 to 10, 4 to 10, or 6 to 10. Examples of the cycloalkenylene group may include a cyclopropenylene group, a cyclobutenylene group, a cyclopentenylene group, a cyclohexenylene group, and a norbornenylene group.

In the formula (D-1), R_{d3}s each independently represent a substituent. The substituent represented by R_{d3} is the same as the substituent represented by R_{c2} in the formula (C-1), that is, the same as the substituent that is optionally contained in the aromatic ring in X_{C}, while including preferred examples thereof.

In the formula (D-1), nd1 represents a number of 0 to 4, preferably 0 to 3, more preferably 0 to 2, and further preferably 0 or 1.

Examples of X_{D} represented by the formula (D-1), which is preferable from the viewpoint of achieving a cured product exhibiting even more excellent dielectric properties and also exhibiting even more favorable mechanical properties in combination with the cross-linkable resin, are shown below.

In one preferred embodiment, in the formula (D-1),
R_{d1} and R_{d2} each independently represent a linear alkylene group of 1 to 6 carbon atoms (preferably 1 to 3 carbon atoms),
R_{d3}s each independently represent an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, or an alkoxy group of 1 to 6 carbon atoms, and
nd1 is 0 or 1.

In the formula (D-2), R_{d4} and R_{d5} each independently represent a divalent aliphatic hydrocarbon group. The divalent aliphatic hydrocarbon groups represented by R_{d4} and R_{d5} are the same as the divalent aliphatic hydrocarbon groups represented by R_{d1} and R_{d2} in the formula (D-1), while including preferred examples thereof.

In the formula (D-2), R_{d6}s each independently represent a substituent. The substituent represented by R_{d6} is the same as the substituent represented by R_{d3} in the formula (D-1), that is, the same as the substituent that is optionally contained in the aromatic ring in X_{C}, while including preferred examples thereof.

In the formula (D-2), nd2's each independently represent a number of 0 to 4, preferably 0 to 3, more preferably 0 to 2, and further preferably 0 or 1.

Examples of X_{D} represented by the formula (D-2), which is preferable from the viewpoint of achieving a cured product exhibiting even more excellent dielectric properties and also exhibiting even more favorable mechanical properties in combination with the cross-linkable resin, are shown below.

In one preferred embodiment, in the formula (D-2),
R_{d4} and R_{d5} each independently represent a linear alkylene group of 1 to 6 carbon atoms (preferably 1 to 3 carbon atoms),
R_{d6}s each independently represent an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, or an alkoxy group of 1 to 6 carbon atoms, and
nd2's are each independently 0 or 1.

In particular, the divalent organic group represented by the formula (D-1), which is preferable from the viewpoint of achieving a cured product exhibiting even more excellent dielectric properties and also exhibiting even more favorable mechanical properties in combination with the cross-linkable resin, is a divalent organic group represented by the following formula (d2-1), and the divalent organic group represented by the preferred formula (D-2) is a divalent organic group represented by the following formula (d2-2). 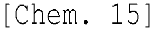 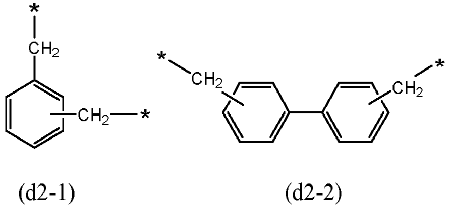 (in the formula, * represents a bond.)

Thus, in one preferred embodiment, X_{D} is
(i) a divalent aliphatic hydrocarbon group, or
(ii) a divalent organic group represented by the above-mentioned formula (d2-1) or (d2-2).

The polyester resin of the present invention contains the structural unit (1) which is the oligomer unit of the above-mentioned X_{C} and X_{D}, and is characterized in that the terminal thereof is an aromatic oxycarbonyl group. Thus, the polyester resin of the present invention can be blended into a resin composition to serve as a crosslinking agent of a cross-linkable resin.

In the polyester resin of the present invention, the structure of the aromatic oxycarbonyl group at its terminal is not particularly limited as long as the resin exhibits cross-linking properties as the cross-linkable resin. The aromatic oxycarbonyl group at its terminal may have a structure of an aromatic-carbon-O-C(=O)- as the ester bond portion. Preferably, when X_{A} represents a monovalent aromatic group, it has a structure of X_{A}-O-C(=O)-.

The monovalent aromatic group represented by X_{A} is as described above, and is preferably an aryl group optionally having a substituent from the viewpoint of further benefiting from the advantageous effects of the present invention. The number of carbon atoms in the aryl group in X_{A} is preferably 6 to 18, more preferably 6 to 14, and further preferably 6 to 10. The number of carbon atoms does not include the number of carbon atoms in the substituent. In one preferred embodiment, the monovalent aromatic group represented by X_{A} is a phenyl group optionally having a substituent or a naphthyl group optionally having a substituent, and more preferably a naphthyl group optionally having a substituent.

The substituents that are optionally contained in the aryl group in X_{A} are as described above. Among these, the substituent is preferably one or more types selected from a halogen atom, a hydrocarbon group, and an alkoxy group. As the halogen atom, a fluorine atom is preferable. Furthermore, the hydrocarbon group and the alkoxy group used as the substituent are as described above. Among these, one or more types selected from a fluorine atom, a hydrocarbon group of 1 to 10 carbon atoms, and an alkoxy group of 1 to 10 carbon atoms are more preferable as the substituent. One or more types selected from a fluorine atom, an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, and an alkoxy group of 1 to 6 carbon atoms are more preferable.

When the aryl group in X_{A} has an unsaturated aliphatic hydrocarbon group as a substituent, the unsaturated aliphatic hydrocarbon group is preferably an alkenyl group or an alkynyl group, more preferably an alkenyl group, and further preferably an allyl group.

In one embodiment, the polyester resin of the present invention is represented by the following general formula (X): 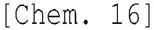 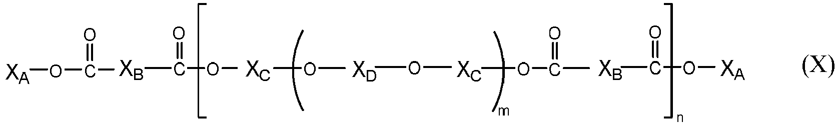 (in the formula,
X_{C}, X_{D} and m are the same as above,
X_{A}s each independently represent a monovalent aromatic group,
X_{B}s each independently represent a divalent organic group, and
n represents an average value of the number of repetitions, and is a number satisfying 0 < n ≤ 10.).

In the general formula (X), X_{C} and X_{D} are as described above for the structural unit (1), while including preferred examples thereof.

In the general formula (X), X_{A} is as described for the terminal aromatic oxycarbonyl group. In one preferred embodiment, X_{A}s are each independently represented by the formula (A-1) or (A-2): 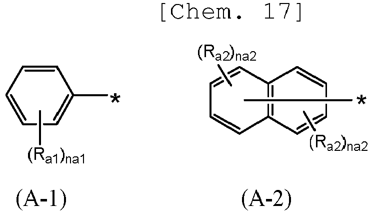 (in the formulas,
Rₐ₁ and Rₐ₂ each independently represent a substituent,
na1 represents a number of 0 to 5,
na2's each independently represent a number of 0 to 4,
* represents a bond.)

The substituents represented by Rₐ₁ and Rₐ₂ are also as described for the terminal aromatic oxycarbonyl group. Among these, as the substituent, one or more types selected from a halogen atom, a hydrocarbon group, and an alkoxy group are preferable. One or more types selected from a fluorine atom, a hydrocarbon group of 1 to 10 carbon atoms, and an alkoxy group of 1 to 10 carbon atoms are more preferable, and one or more types selected from a fluorine atom, an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms and an alkoxy group of 1 to 6 carbon atoms are further preferable.

In the formula (A-1), na1 represents a number of 0 to 5, and in the formula (A-2), na2's each independently represent a number of 0 to 4.

In the general formula (X), X_{B}s each independently represent a divalent organic group. The divalent organic group is as described above, and among these, a divalent aromatic group or a divalent aliphatic group is preferable.

The divalent aromatic group represented by X_{B} is preferably an arylene group optionally having a substituent, from the viewpoint of further benefiting from the advantageous effects of the present invention. The number of carbon atoms in the arylene group in X_{B} is preferably 6 to 18, more preferably 6 to 14, and further preferably 6 to 10. The number of carbon atoms does not include the number of carbon atoms in the substituent. In one preferred embodiment, the divalent aromatic group represented by X_{B} is a phenylene group optionally having a substituent or a naphthylene group optionally having a substituent, and more preferably a phenylene group optionally having a substituent.

The divalent aliphatic group represented by X_{B} is preferably an alkylene group optionally having a substituent or an alkenylene group optionally having a substituent, from the viewpoint of further benefiting from the advantageous effects of the present invention. The alkylene group and the alkenylene group in X_{B} may be either linear or branched. The number of carbon atoms in the divalent aliphatic group represented by X_{B} is preferably 4 or more, more preferably 6 or more, or 8 or more. The upper limit thereof is not particularly limited, and may be usually 30 or less, 20 or less, 18 or less, or the like. The number of carbon atoms does not include the number of carbon atoms in the substituent.

The substituents that are optionally contained in the divalent group in X_{B} are as described above. Among these, one or more types selected from a halogen atom, a hydrocarbon group and an alkoxy group are preferable as the substituent, and one or more types selected from a fluorine atom, a hydrocarbon group of 1 to 10 carbon atoms, and an alkoxy group of 1 to 10 carbon atoms are more preferable. Furthermore, one or more types selected from a fluorine atom, an alkyl group of 1 to 6 carbon atoms, an aryl group of 6 to 10 carbon atoms, an arylalkyl group of 7 to 10 carbon atoms, an unsaturated aliphatic hydrocarbon group of 2 to 6 carbon atoms, and an alkoxy group of 1 to 6 carbon atoms are still further preferable.

In the general formula (X), m is as described above for the structural unit (1), including its preferable range thereof. In particular, m is preferably a number satisfying 0 < m ≤ 3.

In the general formula (X), n represents an average value of the number of repetitions, and is a number satisfying 0 < n ≤ 10. From the viewpoint of achieving a cured product exhibiting excellent dielectric properties and also favorable mechanical properties in combination with the cross-linked resin, the lower limit of n in the general formula (X) is greater than 0, preferably 0.5 or more, more preferably 1 or more, 1.2 or more or 1.4 or more, and further preferably 1.5 or more, 1.6 or more, 1.8 or more or 2 or more. The upper limit of n is preferably 8 or less, 6 or less, 5 or less, 4 or less, or 3 or less. Therefore, in one preferred embodiment, m in the general formula (X) is a number satisfying 0 < m ≤ 3, and n is a number satisfying 0 < n ≤ 3.

In the polyester resin of the present invention, the equivalent weight (equivalent weight of active ester group) of the oxycarbonyl group is preferably 250 g/eq. or more, more preferably 260 g/eq. or more, further preferably 280 g/eq. or more, and 300 g/eq. or more. The upper limit of the equivalent weight of the oxycarbonyl group can be, for example, 1,000 g/eq. or less, 750 g/eq. or less, 700 g/eq. or less, 600 g/eq. or less, or 500 g/eq. or less, or the like.

The number-average molecular weight (Mn) of the polyester resin of the present invention is preferably 5,000 or less, more preferably 4,000 or less, further preferably 3,500 or less, or 3,000 or less, from the viewpoint of blending the polyester resin to the resin composition as a crosslinking agent of the cross-linkable resin. The lower limit of Mn is not particularly limited as long as the polyester resin has the above-mentioned desired structure containing the structural unit (1), and may be, for example, 600 or more, and 800 or more. Mn of the polyester resin of the present invention may be measured as a polystyrene-equivalent value by a gel permeation chromatography (GPC) method. The above-mentioned preferable range of Mn is based on values measured according to the methods in the below-described section of (GPC measuring conditions).

An example of the procedure for synthesizing the polyester resin of the present invention will be described below.

In one embodiment, the polyester resin of the present invention is a condensation reaction product of:
(x1) an aromatic dihydroxy oligomer compound represented by the following general formula (x1);
(x2) a divalent organic carboxylic acid compound or a divalent organic carboxylic acid halide compound; and
(x3) a monovalent hydroxy compound having an aromatic hydroxy group. 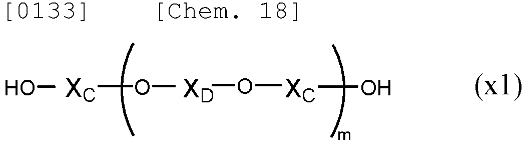
(in the formula, X_{C}, X_{D}, and m are the same as described above.)

### - (x1) Aromatic dihydroxy oligomer compound -

The component (x1) is a dihydroxy compound that contains the structural unit (1) which is an oligomer unit that includes X_{C} and X_{D} described above. By using the component (x1), a polyester resin containing the structural unit (1) can be synthesized.

The component (x1) is a dehydrohalogenation reaction product of
a divalent aromatic hydroxy compound represented by the following general formula (x1-c), and
a divalent organic halide compound represented by the following general formula (x1-d).
   [Chem. 19]

   HO-X_{C}-OH (x1-c)

   (in the formula, X_{C} is the same as described above.) 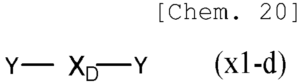 (in the formula, X_{D} is the same as described above, and Y represents a halogen atom.)

As the divalent aromatic hydroxy compound (x1-c), any divalent aromatic hydroxy compound may be used in order to achieve the desired structure of X_{C} in the polyester resin. Preferred embodiments of X_{C} are as described above. Examples of such a divalent aromatic hydroxy compound that achieves the structure of X_{C} represented by the aforementioned formula (C-1) may include a biphenyl compound, an addition reaction product that is produced from a phenol and an unsaturated aliphatic cyclic compound containing two double bonds within one molecule, and various bisphenol compounds. Examples of the addition reaction product of an unsaturated aliphatic cyclic compound and a phenol may include addition reaction products of an unsaturated aliphatic cyclic compound such as dicyclopentadiene, tetrahydroindene, norbornadiene, limonene, or vinylcyclohexene, and a phenol optionally having a substituent (e.g., phenol, cresol, xylenol, ethylphenol, propylphenol, vinylphenol, allylphenol, phenylphenol, benzylphenol, halophenol, etc.). Specific examples thereof may include a dicyclopentadiene-phenol adduct (a dicyclopentadiene-modified phenol resin). Examples of the bisphenol compound may include a bisphenol A, a bisphenol F, a bisphenol AF, a bisphenol AP, a bisphenol B, a bisphenol BP, a bisphenol C, and a bisphenol M. Furthermore, examples of the divalent aromatic dihydroxy compound that can achieve the structure of X_{C} represented by the above-mentioned formula (C-2) may include diols in which two hydroxy groups are bonded to carbon atoms on the naphthalene ring (2,7-naphthalene diol, 1,4-naphthalene diol, 1,5-naphthalene diol, 1,6-naphthalene diol, 2,6 naphthalene diol, and the like). Examples of the divalent aromatic dihydroxy compound that can achieve the structure of X_{C} represented by the above-mentioned formula (C-3) may include a binaphthol compound and various bisnaphthol compounds.

From the viewpoint of further benefiting from the advantageous effects of the present invention, the hydroxyl equivalent (Eq1) of the divalent aromatic hydroxy compound (x1-c) is preferably 70 g/eq. or more, more preferably 80 g/eq. or more, 100 g/eq. or more, 120 g/eq. or more or 140 g/eq. or more, and further preferably 150 g/eq. or more or 160 g/eq. or more. The upper limit of the hydroxyl equivalent Eq1 is not particularly limited, and may be, for example, 500 g/eq. or less, 450 g/eq. or less, or 400 g/eq. or less.

As the divalent organic halide compound (x1-d), any divalent organic halide compound may be used in order to achieve the desired structure of X_{D} in the polyester resin. Preferable examples of X_{D} are as described above. For example, when the desired X_{D} is a linear alkylene group of 2 carbon atoms, 1,2-dibromoethane or 1,2-dichloroethane may be used. When the target X_{D} is a linear alkylene group of 4 carbon atoms, 1,4-dibromobutane or 1,4-dichlorobutane may be used. When the target X_{D} is a linear alkylene group of 8 carbon atoms, 1,8-dibromooctane or 1,8-dichlorooctane may be used. When the desired X_{D} is X_{D} represented by the above-mentioned formula (d2-1), dihaloxylenes such as xylene dichloride and xylene dibromide may be used. When the target X_{D} is X_{D} represented by the above-mentioned formula (d2-2), bis(chloromethyl)biphenyl and bis(bromomethyl)biphenyl may be used.

The aromatic dihydroxy oligomer compound (x1) can be synthesized by a dehydrohalogenation reaction of the component (x1-c) with the component (x1-d), and the value of m in the aromatic dihydroxy oligomer compound (x1), as well as the value of m in the structural unit (1) can be adjusted according to the degree of reaction completion. The hydroxyl equivalent (Eq2; here, Eq2 > Eq1) of the thus synthesized aromatic dihydroxy oligomer compound (x1) is preferably 100 g/eq. or more, more preferably 120 g/eq. or more, 140 g/eq. or more, 150 g/eq. or more, 160 g/eq. or more, 180 g/eq. or more, 200 g/eq. or more, 220 g/eq. or more, or 240 g/eq. or more, further preferably 250 g/eq. or more, 260 g/eq. or more or 280 g/eq. or more. The upper limit of the hydroxyl equivalent Eq2 is not particularly limited, and can be, for example, 2,000 g/eq. or less, 1,500 g/eq. or less, 1,400 g/eq. or less, 1,200 g/eq. or less, or 1,000 g/eq. or less.

The aromatic dihydroxy oligomer compound (x1) may be purified after reaction. Purification may be performed in a manner similar to that described below in connection with the condensation reaction of the component (x1), the component (x2), and the component (x3).

### - Divalent organic carboxylic acid (halide) compound (x2) -

The component (x2) is a divalent organic carboxylic acid compound or a divalent organic carboxylic acid halide compound, and is represented by the following formula (x2): 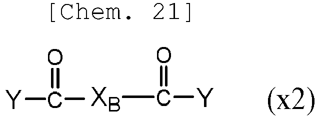 (in the formula, X_{B} is the same as described above, and Y represents a hydroxyl group or a halogen atom.)

As the component (x2), any divalent organic carboxylic acid (halide) compound may be used depending on X_{B} in the desired polyester resin. Preferable examples of X_{B} are as described above. For example, if X_{B} in the desired polyester resin is a phenylene group optionally having a substituent, an isophthalic acid (chloride) optionally having a substituent or a terephthalic acid (chloride) optionally having a substituent may be used.

### - Monovalent hydroxy compound (x3) having aromatic hydroxy group -

The component (x3) is a monovalent hydroxy compound having an aromatic hydroxy group and is represented by the following formula (x3):

[Chem. 22]

X_{A}-OH (x3)

(in the formula, X_{A} is the same as described above.)

Any aromatic monool may be used as the component (x3) according to X_{A} in the desired polyester resin. Preferable examples of X_{A} are as described above. For example, as such an aromatic monool, if X_{A} in the desired polyester resin is a naphthyl group optionally having a substituent, a naphthol optionally having a substituent may be used. If X_{A} in the desired polyester resin is a phenyl group optionally having a substituent, a phenol optionally having a substituent may be used.

In the condensation reaction of the component (x1), the component (x2), and the component (x3), condensation (esterification) proceeds between the component (x2) and the component (x1) and between the component (x2) and the component (x3). In such a reaction, a condensation degree between the component (x2) and the component (x1) can be adjusted by changing conditions, such as amount ratios of respective components, and the like, and so the structure of the resulting polyester resin (the number of repetitions n) can be adjusted.

The condensation reaction may be proceeded in a solvent-free system without using a solvent or in an organic solvent system using an organic solvent. Examples of the organic solvent used in the condensation reaction may include a ketone-based solvent such as acetone, methyl ethyl ketone, methyl isobutyl ketone, and cyclohexanone; an acetic acid ester-based solvent such as ethyl acetate, butyl acetate, cellosolve acetate, propylene glycol monomethyl ether acetate, and carbitol acetate; a carbitol-based solvent such as cellosolve and butyl carbitol; an aromatic hydrocarbon solvent such as toluene and xylene; and an amide-based solvent such as N,N-dimethylformamide, N,N-dimethylacetamide, and N-methyl-2-pyrrolidone. As the organic solvent, one type thereof may be solely used, and two or more types thereof may also be used in combination.

A base may be used in the condensation reaction. Examples of the base may include: an alkali metal hydroxide such as sodium hydroxide (caustic soda) and potassium hydroxide; and a tertiary amine such as triethylamine, pyridine, and N,N-dimethyl-4-aminopyridine (DMAP). As the base, one type thereof may be solely used, and two or more types thereof may also be used in combination.

A condensation agent and a phase transfer catalyst may also be used in the condensation reaction. As these agents, any conventionally known agents that can be used in the esterification reaction may be used.

The reaction temperature in the condensation reaction is not particularly limited as long as the condensation reaction is proceeded. For example, the reaction temperature may be in a range of 0 to 80°C. Furthermore, the reaction time in the condensation reaction is not particularly limited as long as the desired structure of the polyester resin is achieved. For example, the reaction time may be in a range of 30 minutes to 8 hours.

The polyester resin may be purified after the condensation reaction. For example, a purification step such as washing with water or microfiltration may be performed after the condensation reaction to remove by-product salts and excessive starting materials from the system. Specifically, after the condensation reaction, water is added in an amount necessary for dissolving the by-product salts, and an aqueous layer obtained by static liquid separation is discarded. Furthermore, an acid is added as needed for neutralization, and washing with water is performed. These processes are repeated. Then, a dehydration process is performed using a chemical agent or by azeotropic distillation, followed by microfiltration to remove impurities for purification. Subsequently, as necessary, the organic solvent is removed by distillation to obtain the polyester resin. The organic solvent may not be completely removed and the remaining organic solvent may be used as is as a solvent for the resin composition.

The polyester resin of the present invention can achieve a cured product exhibiting excellent dielectric properties and also favorable mechanical properties in combination with the cross-linkable resin. Furthermore, the polyester resin of the present invention can achieve the low transmission loss required for 5G applications and can suppress the occurrence of crack defects around vias. Thus, in one preferred embodiment, the polyester resin of the present invention can be suitably used as a resin cross-linking agent.

### [Resin composition]

The polyester resin of the present invention can be used to produce a resin composition. The present invention also provides such a resin composition.

The resin composition of the present invention includes a polyester resin (X) and a cross-linkable resin (Y), and the polyester resin (X) contains the polyester resin of the present invention, that is, the structural unit (1) which is an oligomer unit of the above-mentioned X_{C} and X_{D}, and is a polyester resin having an aromatic oxycarbonyl group at its terminal.

Preferred structures of the structural unit (1), a preferred range of the equivalent weight of oxycarbonyl groups, and details of the polyester resin (X) are as described in the section of [Polyester resin].

In the resin composition of the present invention, the type of the cross-linkable resin (Y) is not particularly limited as long as it can be crosslinked in combination with the polyester resin (X). The cross-linkable resin (Y) is preferably one or more types selected from the group consisting of a thermosetting resin and a radically polymerizable resin from the viewpoint of achieving a cured product exhibiting excellent dielectric properties and also favorable mechanical properties in combination with the polyester resin (X).

As the thermosetting resin and the radically polymerizable resin, known resins used in forming an insulating layer for a printed wiring board or a semiconductor chip package may be used. Hereinafter, a thermosetting resin and a radically polymerizable resin that can be used as the cross-linkable resin (Y) will be described.

Examples of the thermosetting resin may include an epoxy resin, a benzocyclobutene resin, an epoxy acrylate resin, a urethane acrylate resin, a urethane resin, a cyanate resin, a polyimide resin, a benzoxazine resin, an unsaturated polyester resin, a phenol resin, a melamine resin, a silicone resin, and a phenoxy resin. As the thermosetting resin, one type thereof may be solely used, and two or more types thereof may also be used in combination. Among these, the cross-linkable resin (Y) preferably includes an epoxy resin from the viewpoint of achieving a cured product that is more excellent in both dielectric properties and mechanical properties in combination with the polyester resin (X).

The type of the epoxy resin is not particularly limited as long as it has one or more (preferably two or more) epoxy groups within one molecule. Examples of the epoxy resin may include a bisphenol A type epoxy resin, a bisphenol F type epoxy resin, a bisphenol S type epoxy resin, a bisphenol AF type epoxy resin, a phenol novolac type epoxy resin, a tert-butyl-catechol type epoxy resin, a naphthol type epoxy resin, a naphthalene type epoxy resin, a naphthylene ether type epoxy resin, a glycidyl amine type epoxy resin, a glycidyl ester type epoxy resin, a cresol novolac type epoxy resin, a biphenyl type epoxy resin, a phenol aralkyl type epoxy resin, a biphenyl aralkyl type epoxy resin, a fluorene-skeleton type epoxy resin, a dicyclopentadiene type epoxy resin, an anthracene type epoxy resin, a linear aliphatic epoxy resin, an epoxy resin having a butadiene structure, an alicycle-containing epoxy resin, a heterocyclic epoxy resin, a spirocyclic epoxy resin, a cyclohexanedimethanol type epoxy resin, a trimethylol type epoxy resin, and a halogenated epoxy resin. According to the resin composition of the present invention containing the polyester resin (X), it is possible to achieve a cured product exhibiting excellent dielectric properties and also favorable mechanical properties regardless of the type of the epoxy resin.

The epoxy resin may be classified into epoxy resins in a liquid state at a temperature of 20°C (hereinafter referred to as a "liquid epoxy resin") and epoxy resins in a solid state at a temperature of 20°C (hereinafter referred to as a "solid epoxy resin"), and the resin composition of the present invention may contain only a liquid epoxy resin as the cross-linkable resin (Y), may contain only a solid epoxy resin, or may contain a combination of a liquid epoxy resin and a solid epoxy resin. When a combination of a liquid epoxy resin and a solid epoxy resin is contained, the blending ratio (liquid : solid) may be in a range of 20:1 to 1:20 by mass ratio (preferably 10:1 to 1:10, more preferably 3:1 to 1:3).

The equivalent weight of the epoxy group of the epoxy resin is preferably 50 g/eq. to 2,000 g/eq., more preferably 60 g/eq. to 1,000 g/eq., and further preferably 80 g/eq. to 500 g/eq. The equivalent weight of the epoxy group is a mass of the epoxy resin containing one equivalent of epoxy groups and may be measured according to JIS K7236.

The weight-average molecular weight (Mw) of the epoxy resin is preferably 100 to 5,000, more preferably 250 to 3,000, and further preferably 400 to 1,500. Mw of the epoxy resin may be measured as a polystyrene equivalent value by a GPC method.

The type of the radically polymerizable resin is not particularly limited as long as it has one or more (preferably two or more) radically polymerizable unsaturated groups within one molecule. Examples of the radically polymerizable resin may include resins containing, as a radically polymerizable unsaturated group, one or more types selected from a maleimide group, a vinyl group, an allyl group, a styryl group, a vinylphenyl group, an acryloyl group, a methacryloyl group, a fumaroyl group, and a maleoyl group. Among these, the cross-linkable resin (Y) preferably contains one or more types selected from a maleimide resin, a (meth)acrylic resin, and a styryl resin, from the viewpoint of achieving a cured product that is more excellent in both dielectric properties and mechanical properties in combination with the polyester resin (X).

The type of the maleimide resin is not particularly limited as long as it has one or more (preferably two or more) maleimide groups (2,5-dihydro-2,5-dioxo-1H-pyrrol-1-yl group) within one molecule. Examples of the maleimide resin may include a maleimide resin containing an aliphatic skeleton of 36 carbon atoms derived from a dimer diamine, such as "BMI-3000J", "BMI-5000", "BMI-1400", "BMI-1500", "BMI-1700", and "BMI-689" (all manufactured by Designer Molecules Inc.); a maleimide resin containing an indane skeleton described in Journal of Technical Disclosure No. 2020-500211 published by Japan Institute for Promoting Invention and Innovation; and a maleimide resin containing an aromatic ring skeleton directly bonded to a nitrogen atom of a maleimide group such as "MIR-3000-70MT" (manufactured by Nippon Kayaku Co., Ltd.), "BMI-4000" (manufactured by Daiwa Fine Chemicals Co., Ltd.), and "BMI-80" (manufactured by K-I Chemical Industry CO., LTD.).

The type of the (meth)acrylic resin is not particularly limited as long as it has one or more (preferably two or more) (meth)acryloyl groups within one molecule. Herein, the term "(meth)acryloyl group" is a generic term for an acryloyl group and a methacryloyl group. Examples of the methacrylic resin may include (meth)acrylic resins such as "A-DOG" (manufactured by Shin-Nakamura Chemical Co., Ltd.), "DCP-A" (manufactured by Kyoeisha Chemical Co., Ltd.), "NPDGA", "FM-400", "R-687", "THE-330", "PET-30", and "DPHA" (all manufactured by Nippon Kayaku Co., Ltd.).

The type of the styryl resin is not particularly limited as long as it has one or more (preferably two or more) styryl groups or vinylphenyl groups within one molecule, and may be a monomer or an oligomer. Examples of the styryl resin may include styryl resins such as "OPE-2St", "OPE-2St 1200", and "OPE-2St 2200" (all manufactured by Mitsubishi Gas Chemical Co., Inc.).

The resin composition of the present invention may contain only a thermosetting resin, only a radically polymerizable resin, or a combination of a thermosetting resin and a radically polymerizable resin, as the cross-linkable resin (Y).

In the resin composition of the present invention, the mass ratio ((X)/(Y)) of the polyester resin (X) to the cross-linkable resin (Y) may be 1 or more, preferably 1.1 or more, and more preferably 1.2 or more. The upper limit of the mass ratio ((X)/(Y)) may be, for example, 2 or less, 1.9 or less, or 1.8 or less. Thus, in an embodiment, the mass ratio ((X)/(Y)) of the polyester resin (X) to the cross-linkable resin (Y) is 1.2 to 2.0.

The resin composition of the present invention may further include an inorganic filler. When the resin composition includes the inorganic filler, the coefficient of linear thermal expansion and the dielectric loss tangent can be further reduced.

Examples of the inorganic filler may include silica, alumina, barium sulfate, talc, clay, mica powder, aluminum hydroxide, magnesium hydroxide, calcium carbonate, magnesium carbonate, magnesium oxide, boron nitride, aluminum borate, barium titanate, strontium titanate, calcium titanate, magnesium titanate, bismuth titanate, titanium oxide, barium zirconate, and calcium zirconate. Among these, silica is preferable. Examples of the silica may include amorphous silica, fused silica, crystalline silica, synthetic silica, and hollow silica. As silica, spherical silica is preferable. As the inorganic filler, one type thereof may be solely used, and two or more types thereof may also be used in combination. Examples of commercially available products of the inorganic filler may include "UFP-30" (manufactured by Denka Co., Ltd.); "YC100C", "YA050C", "YA050C-MJE", "YA010C", "SC2500SQ", "SO-C4", "SO-C2", "SO-C1", and "SC-C2" (all manufactured by Admatechs Co., Ltd.); "Silfil NSS-3N", "Silfil NSS-4N", and "Silfil NSS-5N" (manufactured by Tokuyama Corp.).

The average particle diameter of the inorganic filler is preferably 5 µm or less, more preferably 2 µm or less, and further preferably 1 µm or less, from the viewpoint of making the surface of the cured product (insulating layer) low roughness and facilitating fine wiring formation. The lower limit of the average particle diameter is not particularly limited, and may be, for example, 0.01 µm or more, 0.02 µm or more, or 0.03 µm or more. The average particle diameter of the inorganic filler may be measured by a laser diffraction scattering method based on the Mie scattering theory. Specifically, the average particle diameter may be measured by creating a particle size distribution of the inorganic filler on a volume basis by a laser diffraction scattering particle size distribution measuring apparatus, and using the obtained median diameter as the average particle diameter. As the measurement sample, an inorganic filler dispersed in water by ultrasonic waves may be preferably used. The laser diffraction scattering particle size distribution measuring apparatus to be used may include LA-950 manufactured by Horiba, Ltd. or the like.

The inorganic filler is preferably one obtained by performing a surface treatment with a surfaced treating agent, such as an aminosilane-based coupling agent, a ureidosilane-based coupling agent, an epoxy-silane-based coupling agent, a mercaptosilane-based coupling agent, a vinylsilane-based coupling agent, a styrylsilane-based coupling agent, an acrylate-silane-based coupling agent, an isocyanate-silane-based coupling agent, a sulfide silane-based coupling agent, an organosilazane compound, or a titanate-based coupling agent, to improve its moisture resistance and dispersibility.

When the resin composition of the present invention includes an inorganic filler, the content of the inorganic filler in the resin composition may be determined according to the properties required for the resin composition. When the nonvolatile component in the resin composition is defined as 100% by mass, for example, the content thereof is 5% by mass or more, 10% by mass or more, preferably 30% by mass or more, more preferably 40% by mass or more, and further preferably 50% by mass or more. The upper limit of the content of the inorganic filler is not particularly limited, and may be, for example, 90% by mass or less, and 80% by mass or less.

The resin composition of the present invention may further contain a resin crosslinking agent other than the polyester resin (X).

Examples of resin cross-linking agents other than the polyester resin (X) may include a phenol-based curing agent, such as "TD2090" and "TD2131" (manufactured by DIC Corp.), "MEH-7600", "MEH-7851", and "MEH-8000H" (manufactured by Meiwa Plastic Industries, Ltd.), "NHN", "CBN", "GPH-65", and "GPH-103" (manufactured by Nippon Kayaku Co., Ltd.), "SN170", "SN180", "SN190", "SN475", "SN485", "SN495", "SN375", and "SN395" (manufactured by Nippon Steel Chemical & Materials Co., Ltd.), and "LA7052", "LA7054", "LA3018", and "LA1356" (manufactured by DIC Corp.); a benzoxazine-based crosslinking agent such as "F-a" and "P-d" (manufactured by Shikoku Chemicals Corp.), and "HFB2006M" (manufactured by Showa Highpolymer Co., Ltd.); an acid anhydride crosslinking agent such as methylhexahydrophthalic anhydride, methylnadic anhydride, and hydrogenated methylnadic anhydride; a cyanate ester-based crosslinking agent such as PT30, PT60, and BA230S75 (manufactured by LONZA K.K.); and a benzoxazine-based crosslinking agent.

When the resin composition of the present invention includes a resin crosslinking agent other than the polyester resin (X), the content of the resin crosslinking agent in the resin composition may be determined according to the properties required for the resin composition. When the nonvolatile component in the resin composition is defined as 100% by mass, the content thereof is preferably 40% by mass or less, more preferably 20% by mass or less, and further preferably 10% by mass or less, and the lower limit thereof is 0.01% by mass or more, 0.05% by mass or more, or 0.1% by mass or more.

The resin composition of the present invention may further contain a crosslinking accelerator. By containing the crosslinking accelerator, the crosslinking time and the crosslinking temperature can be efficiently adjusted.

Examples of the crosslinking accelerator may include an organophosphine compound such as "TPP", "TPP-K", and "TPTP-S" (manufactured by Hokko Chemical Industry Co., Ltd.); an imidazole compound such as "Cuazole 2MZ", "2E4MZ", "Cl1Z", "Cl1Z-CN", "Cl1Z-CNS", "Cl1Z-A", "2MZ-OK", "2MA-OK", and "2PHZ" (manufactured by Shikoku Chemicals Corp.); an amine adduct compound such as Novacure (manufactured by Asahi Kasei Corp.) and Fijicure (manufactured by Fuji Kasei Kogyo Co., Ltd.); an amine compound such as 1,8-diazabicyclo[5,4,0]undecene-7,4-dimethylaminopyridine, benzyldimethylamine, 2,4,6-tris(dimethylaminomethyl)phenol, and 4-dimethylaminopyridine; and organometallic complexes or organometallic salts of such as cobalt, copper, zinc, iron, nickel, manganese, tin, and the like.

When the resin composition of the present invention includes a crosslinking accelerator, the content of the crosslinking accelerator in the resin composition may be determined according to the properties required for the resin composition. When the non-volatile component in the resin composition is defined as 100% by mass, the content thereof is preferably 10% by mass or less, more preferably 5% by mass or less, and further preferably 1% by mass or less, and the lower limit thereof is 0.001% by mass or more, 0.01% by mass or more, and 0.05% by mass or more.

The resin composition of the present invention may further contain an optional additive. Examples of the additive may include an organic filler such as rubber particles; a radical polymerization initiator such as a peroxide-based radical polymerization initiator and an azo-based radical polymerization initiator; a thermoplastic resin such as a phenoxy resin, a polyvinyl acetal resin, a polysulfone resin, a polyether sulfone resin, a polyphenylene ether resin, a polyether ether ketone resin, and a polyester resin; an organometallic compound such as an organocopper compound, an organozinc compound, and an organocobalt compound; a colorant such as phthalocyanine blue, phthalocyanine green, iodine green, diazo yellow, crystal violet, titanium oxide, and carbon black; a polymerization inhibitor such as hydroquinone, catechol, pyrogallol, and phenothiazine; a leveling agent such as a silicone-based leveling agent and an acrylic polymer-based leveling agent; a thickener such as bentone and montmorillonite; a defoamer such as a silicon-based defoamer, an acrylic-based defoamer, a fluorine-based defoamer, and a vinyl-based defoamer; a UV absorber such as a benzotriazole-based UV absorber; an adhesion improver such as urea silane; an adhesion imparting agent such as a triazole-based adhesion imparting agent, a tetrazole-based adhesion imparting agent, and a triazine-based adhesion imparting agent; an antioxidant such as a hindered phenol-based antioxidant; a fluorescent brightener such as a stilbene derivative; a surfactant such as a fluorine-based surfactant and a silicone-based surfactant; a flame retardant such as a phosphorus-based flame retardant (e.g., a phosphate ester compound, a phosphazene compound, a phosphinic acid compound, and red phosphorus), a nitrogen-based flame retardant (e.g., melamine sulfate), a halogen-based flame retardant, and an inorganic flame retardant (e.g., antimony trioxide); a dispersant such as a phosphate-based dispersant, a polyoxyalkylene-based dispersant, an acetylene-based dispersant, a silicone-based dispersant, an anionic dispersant, and a cationic dispersant; and a stabilizer such as a borate-based stabilizer, a titanate-based stabilizer, an aluminate-based stabilizer, a zirconate-based stabilizer, an isocyanate-based stabilizer, a carboxylic acid-based stabilizer, and a carboxylic anhydride-based stabilizer. The content of such additives may be determined according to the properties required for the resin composition.

The resin composition of the present invention may further contain an organic solvent as a volatile component. Examples of the organic solvent may include: a ketone-based solvent such as acetone, methyl ethyl ketone, methyl isobutyl ketone, and cyclohexanone; an ester-based solvent such as methyl acetate, ethyl acetate, butyl acetate, isobutyl acetate, isoamyl acetate, methyl propionate, ethyl propionate, and γ-butyrolactone; an ether-based solvent such as tetrahydropyran, tetrahydrofuran, 1,4-dioxane, diethyl ether, diisopropyl ether, dibutyl ether, and diphenyl ether; an alcohol-based solvent such as methanol, ethanol, propanol, butanol, and ethylene glycol; an ether ester-based solvent such as 2-ethoxyethyl acetate, propylene glycol monomethyl ether acetate, diethylene glycol monoethyl ether acetate, ethyl diglycol acetate, γ-butyrolactone, and methyl methoxypropionate; an ester alcohol-based solvent such as methyl lactate, ethyl lactate, and methyl 2-hydroxyisobutyrate; an ether alcohol-based solvent such as 2-methoxypropanol, 2-methoxyethanol, 2-ethoxyethanol, propylene glycol monomethyl ether, and diethylene glycol monobutyl ether (butyl carbitol); an amide-based solvent such as N,N-dimethylformamide, N,N-dimethylacetamide, and N-methyl-2-pyrrolidone; a sulfoxide-based solvent such as dimethyl sulfoxide; a nitrile-based solvent such as acetonitrile and propionitrile; an aliphatic hydrocarbon-based solvent such as hexane, cyclopentane, cyclohexane, and methylcyclohexane; and an aromatic hydrocarbon-based solvent such as benzene, toluene, xylene, ethylbenzene, and trimethylbenzene. As the organic solvent, one type thereof may be solely used, and two or more types thereof may also be used in combination.

When the resin composition of the present invention contains an organic solvent, the content of the organic solvent in the resin composition may be determined according to the properties required for the resin composition. When all the components in the resin composition are defined as 100% by mass, for example, the content thereof may be set to 60% by mass or less, 40% by mass or less, 30% by mass or less, 20% by mass or less, 150 by mass or less, 10% by mass or less, or the like.

The resin composition of the present invention may be prepared by appropriately mixing the necessary components, among those mentioned above, and kneading or mixing by a kneading means such as a three-roll roll, a ball mill, a bead mill, a sand mill, or the like, or a stirring means such as a super mixer, a planetary mixer, or the like as necessary.

The resin composition of the present invention, which includes the polyester resin (X) and the cross-linkable resin (Y) in combination, can achieve the cured product exhibiting excellent dielectric properties and also favorable mechanical properties.

In an embodiment, the cured product of the resin composition of the present invention has a characteristic of having a low dielectric constant (Dk). For example, the dielectric constant (Dk) of the cured product of the resin composition of the present invention can be preferably 3.2 or less, 3.1 or less, 3.0 or less, 2.9 or less, or 2.8 or less, when measured at 5.8 GHz and 23°C as described in the section of [Dielectric properties] below.

In an embodiment, the cured product of the resin composition of the present invention has a characteristic of having a low dielectric loss tangent (Df). For example, the dielectric loss tangent (Df) of the cured product of the resin composition of the present invention can be preferably 0.01 or less, 0.008 or less, 0.006 or less, 0.005 or less, 0.004 or less, or 0.003 or less, when measured at 5.8 GHz and 23°C as described in the section of [Dielectric properties] below.

In an embodiment, the cured product of the resin composition of the present invention has a characteristic of having excellent mechanical properties (elongation at break). For example, when performing a tension test in accordance with JIS K7127 as described in the section of [Mechanical properties] to be described later, elongation at break of the cured product of the resin composition of the present invention is preferably 1.5% or more, 1.6% or more, 1.7% or more or 1.8% or more.

The resin composition of the present invention can also achieve a cured product exhibiting excellent dielectric properties and also favorable mechanical properties. Furthermore, the resin composition can achieve the low transmission loss required for 5G applications and can suppress the occurrence of crack defects around vias. Thus, the resin composition of the present invention can be suitably used as a resin composition for forming an insulation layer of a printed wiring board (resin composition for an insulation layer of a printed wiring board), and more suitably used as a resin composition for forming an interlayer insulation layer of a printed wiring board (resin composition for an interlayer insulation layer of printed wiring board). The resin composition of the present invention can also be suitably used in a case where the printed wiring board is a component-embedded circuit board. The resin composition of the present invention can also be suitably used as a resin composition for sealing a semiconductor chip (resin composition for sealing semiconductor). The resin composition capable of significantly reducing a delamination defect in a via or a wiring pattern can be suitably used as a resin composition for the redistribution forming layer as an insulation layer for forming the redistribution layer (resin composition for a redistribution forming layer). The resin composition of the present invention can also be used in a wide range of applications where a resin composition is required, such as a sheet-like laminated material such as a resin sheet or a prepreg, a solder resist, an underfill material, a die bonding material, a hole-filling resin, and a component-embedding resin.

### [Sheet-like laminated material (resin sheet and prepreg)]

The resin composition of the present invention can be used as it is. However, it is suitably used in the form of a sheet-like laminated material including the resin composition.

As the sheet-like laminated material, the following resin sheet and prepreg are preferable.

In an embodiment, the resin sheet includes a support and a layer of the resin composition disposed on the support (hereinafter, simply referred to as "resin composition layer"), and the resin composition layer is formed of the resin composition of the present invention.

The thickness of the resin composition layer varies in preferable values depending on applications and may be appropriately determined according to the applications. For example, the thickness of the resin composition layer is preferably 200 µm or less, more preferably 150 µm or less, 120 µm or less, 100 µm or less, 80 µm or less, 60 µm or less, or 50 µm or less, from the viewpoint of reducing the thickness of the printed wiring board or the semiconductor chip package. Although the lower limit of the thickness of the resin composition layer is not particularly limited, it can be usually 1 µm or more, 5 µm or more, or the like.

Examples of the support may include a thermoplastic resin film, a metal foil, and a release paper. Of these, a thermoplastic resin film and a metal foil are preferable. Accordingly, in one embodiment, the support is a thermoplastic resin film or a metal foil.

In a case where a thermoplastic resin film is used as the support, examples of the thermoplastic resin may include a polyester such as a polyethylene terephthalate (PET) and a polyethylene naphthalate (PEN), an acrylic resin such as a polycarbonate (PC) and a polymethyl methacrylate (PMMA), a cyclic polyolefin, a triacetyl cellulose (TAC), a polyether sulfide (PES), a polyether ketone, and a polyimide. Of these, a polyethylene terephthalate and a polyethylene naphthalate are preferable, and an inexpensive polyethylene terephthalate is particularly preferable.

In a case where a metal foil is used as the support, examples of the metal foil may include a copper foil and an aluminum foil. Of these, the copper foil is preferable. As the copper foil, a foil made of a single metal of copper may be used, or a foil made of an alloy of copper and different metal (e.g., tin, chromium, silver, magnesium, nickel, zirconium, silicon, titanium, etc.) may be used.

The support may be subjected to a matte treatment, a corona treatment, and an antistatic treatment on the surface to be bonded to the resin composition layer. Furthermore, as the support, a support with release layer having a release layer on the surface to be bonded to the resin composition layer may be used. A release agent used in the release layer of the support with release layer may be one or more release agents selected from the group consisting of an alkyd resin, a polyolefin resin, a urethane resin, and a silicone resin. A commercially available product may be used as the support with release layer. Examples thereof may include "SK-1", "AL-5", and "AL-7" manufactured by Lintec Corp., which are a PET film with a release layer including an alkyd resin-based release agent as a main component, "LUMIRROR T60" manufactured by Toray Industries, Inc., "PUREX" manufactured by Teijin Ltd., and "UNIPEEL" manufactured by Unitika Ltd.

The thickness of the support is not particularly limited. However, the thickness is preferably in a range of 5 µm to 75 µm, more preferably in a range of 10 µm to 60 µm. Note that, in a case where the support with release layer is used, the thickness of the support with release layer as a whole is preferably within the above-mentioned range.

When the metal foil is used as the support, there may be also used a metal foil with supporting substrate, in which a peelable supporting substrate is bonded to a thin metal foil. In an embodiment, the metal foil with supporting substrate includes a supporting substrate, a release layer disposed on the supporting substrate, and a metal foil disposed on the releasing layer. In a case where the metal foil with supporting substrate is used as the support, the resin composition layer is disposed on the metal foil.

In the metal foil with supporting substrate, a material of the supporting substrate is not particularly limited. However, examples of the material may include a copper foil, an aluminum foil, a stainless-steel foil, a titanium foil, and a copper alloy foil. In a case where a copper foil is used as the supporting substrate, an electrolytic copper foil or a rolled copper foil may be used. Furthermore, the release layer is not particularly limited as long as the metal foil can be released from the supporting substrate. Examples of the release layer may include: an alloy layer of elements selected from the group consisting of Cr, Ni, Co, Fe, Mo, Ti, W, and P; and an organic film.

In the metal foil with supporting substrate, preferable examples of a material of the metal foil may include a copper foil and a copper alloy foil.

In the metal foil with supporting substrate, the thickness of the supporting substrate is not particularly limited. However, the thickness is preferably in a range of 10 µm to 150 µm, more preferably in a range of 10 µm to 100 µm. Furthermore, the thickness of the metal foil may be, for example, in a range of 0.1 µm to 10 µm.

In an embodiment, the resin sheet may further include an optional layer as necessary. Examples of such an optional layer may include a protective film disposed on the surface of the resin composition layer, which is not bonded to the support (i.e., the surface on the opposite side to the support). The thickness of the protective film is not particularly limited. However, the thickness is, for example, 1 µm to 40 µm. Laminating the protective film can prevent the surface of the resin composition layer from being dusted or scratched.

The resin sheet can be produced by, for example, using the liquid resin composition as it is or preparing a resin varnish by dissolving the resin composition in an organic solvent, applying such a resin composition onto the support using a die coater or the like, and then drying the resin composition to form a resin composition layer.

Examples of the organic solvent may include the same organic solvents described as the component of the resin composition. As the organic solvent, one type thereof may be solely used, and two or more types thereof may also be used in combination.

The drying may be performed by a known method such as heating or blowing with hot air. Although a drying condition is not particularly limited, the drying is performed so that the content of the organic solvent in the resin composition layer is reduced to 10% by mass or less, preferably 5% by mass or less. The drying condition varies depending on the boiling point of the organic solvent in the resin composition or the resin varnish. For example, in a case where the resin composition or the resin varnish including 30% by mass to 60% by mass of the organic solvent is used, the resin composition layer can be formed by drying the resin composition or the resin varnish at 50°C to 150°C for 3 minutes to 10 minutes.

The resin sheet can be wound into a roll and stored. In a case where the resin sheet has a protective film, the resin sheet can be used by peeling off the protective film.

In an embodiment, the prepreg is formed by impregnating a sheet-like fiber substrate with the resin composition of the present invention.

The sheet-like fiber substrate used for the prepreg is not particularly limited. A material commonly used as a substrate for prepreg, such as glass cloth, aramid nonwoven fabric, or liquid crystal polymer nonwoven fabric, can be used. From the viewpoint of reducing the thickness of the printed wiring board or the semiconductor chip package, the thickness of the sheet-like fiber substrate is preferably 50 µm or less, more preferably 40 µm or less, further preferably 30 µm or less, and particularly preferably 20 µm or less. The lower limit of the thickness of the sheet-like fiber substrate is not particularly limited. However, it is usually 10 µm or more.

The prepreg can be produced by a known method such as a hot melt method and a solvent method.

The thickness of the prepreg can be in the same range as the resin composition layer in the resin sheet described above.

The sheet-like laminated material of the present invention can be suitably used for forming an insulation layer of the printed wiring board (for an insulation layer of printed wiring board), and more suitably used for forming an interlayer insulation layer of the printed wiring board (for an interlayer insulation layer of printed wiring board). The sheet-like laminated material of the present invention can also be suitably used for sealing the semiconductor chip (for sealing semiconductor). The sheet-like laminated material of the present invention can be suitably used for a redistribution forming layer as an insulation layer for forming the redistribution layer.

### [Printed wiring board]

The printed wiring board of the present invention includes the insulation layer formed of the cured product of the resin composition of the present invention.

The printed wiring board can be produced by, for example, a method including the following steps (I) and (II) using the above-mentioned resin sheet:
(I) a step of laminating a resin sheet on an inner layer substrate so that a resin composition layer of the resin sheet is bonded to the inner layer substrate; and
(II) a step of curing (e.g., thermally curing) the resin composition layer to form an insulation layer.

The "inner layer substrate" used in the step (I) is a member that serves as a substrate of the printed wiring board. Examples of the inner layer substrate may include a glass epoxy substrate, a metal substrate, a polyester substrate, a polyimide substrate, a BT resin substrate, and a thermosetting polyphenylene ether substrate. Furthermore, such a substrate may have a conductor layer on one or both surfaces, and this conductor layer may be patterned. The inner layer substrate having the conductor layer (circuit) formed on one or both surfaces of the substrate is sometimes referred to as an "inner layer circuit substrate". Furthermore, an intermediate product on which the insulation layer and/or the conductive layer are to be formed in the production of the printed wiring board is also included in the "inner layer substrate" as defined in the present invention. In a case where the printed wiring board is a component-embedded circuit board, an inner layer substrate having components embedded may be used.

The lamination of the inner layer substrate and the resin sheet can be performed by, for example, thermocompression bonding of the resin sheet to the inner layer substrate carried out from the support side. Examples of a member for use in performing the thermocompression bonding of the resin sheet to the inner layer substrate (hereinafter also referred to as "thermocompression bonding member") may include a heated metal plate (a SUS head plate, etc.) and a heated metal roll (a SUS roll). Note that the thermocompression bonding member may be directly pressed onto the resin sheet or may be pressed through an elastic material such as heat-resistant rubber so that the resin sheet sufficiently follows the uneven surface of the inner layer substrate.

The lamination of the inner layer substrate and the resin sheet may be performed by a vacuum lamination method. In the vacuum lamination method, the thermocompression bonding temperature is preferably in a range of 60°C to 160°C, more preferably 80°C to 140°C, the thermocompression bonding pressure is preferably in a range of 0.098 MPa to 1.77 MPa, more preferably 0.29 MPa to 1.47 MPa, and the thermocompression bonding time is preferably in a range of 20 seconds to 400 seconds, more preferably 30 seconds to 300 seconds. The lamination can be performed under a reduced pressure condition, preferably at a pressure of 26.7 hPa or less.

The lamination can be performed with a commercially available vacuum laminator. Examples of the commercially available vacuum laminator may include a vacuum pressure laminator manufactured by Meiki Co., Ltd., and a vacuum applicator and a batch type vacuum pressure laminator manufactured by Nikko-Materials Co., Ltd.

After the lamination, the laminated resin sheet may be subjected to a smoothing treatment by, for example, pressing the laminated resin sheet from the support side with the thermocompression member under normal pressure (atmospheric pressure). A pressing condition for the smoothing treatment can be the same as the condition for the thermocompression bonding used for the lamination described above. The smoothing treatment can be performed with a commercially available laminator. Note that the lamination and the smoothing treatment may be performed successively using the commercially available vacuum laminator described above.

The support may be removed between the step (I) and the step (II) or may be removed after the step (II). Note that, in a case where a metal foil is used as the support, the conductive layer may be formed using the metal foil without peeling off the support. Furthermore, in a case where a metal foil with supporting substrate is used as the support, the supporting substrate (and the release layer) is simply peeled off. Then, a conductive layer can be formed using the metal foil.

In the step (II), the resin composition layer is cured (e.g., thermally cured) to form an insulation layer formed of a cured product of the resin composition. A curing condition for the resin composition layer is not particularly limited, and the condition usually employed for forming an insulation layer of the printed wiring board may be used.

The thermal curing condition for the resin composition layer varies depending on the type of the resin composition and the like. However, for example, in an embodiment, the curing temperature is preferably 120°C to 250°C, more preferably 150°C to 240°C, and further preferably 180°C to 230°C. The curing time can be preferably 5 minutes to 240 minutes, more preferably 10 minutes to 150 minutes, and further preferably 15 minutes to 120 minutes.

Before being thermally cured, the resin composition layer may be preheated at a temperature lower than the curing temperature. For example, before being thermally cured, the resin composition layer may be preheated at a temperature of 50°C to 120°C, preferably 60°C to 115°C, more preferably 70°C to 110°C for 5 minutes or more, preferably 5 minutes to 150 minutes, more preferably 15 minutes to 120 minutes, and further preferably 15 minutes to 100 minutes.

In the production of the printed wiring board, a step (III) of perforating the insulation layer, a step (IV) of subjecting the insulation layer to a roughening treatment, and a step (V) of forming a conductive layer may be further performed. These steps (III) to (V) may be performed according to various methods known to those skilled in the art used in the production of the printed wiring board. Note that, in a case where a support is removed after the step (II), the support may be removed between the step (II) and the step (III), between the step (III) and the step (IV), or between the step (IV) and the step (V). Furthermore, if necessary, the steps (I) to (V) of forming the insulation layer and the conductive layer may be repeated to form a multilayer wiring board.

In another embodiment, the printed wiring board of the present invention can be produced using the prepreg described above. A production method is basically the same as the method using the resin sheet.

The step (III) is a step of perforating the insulation layer, whereby a hole such as a via hole or a through hole can be formed in the insulation layer. The step (III) may be performed using, for example, a drill, laser, plasma, or the like, depending on the composition and the like of the resin composition used for forming the insulation layer. The dimension and shape of the hole may be appropriately determined according to a design of the printed wiring board.

The step (IV) is a step of subjecting the insulation layer to a roughening treatment. Usually, removal of smear (desmear) is also performed in this step (IV). A procedure and condition for the roughening treatment are not particularly limited, and a known procedure and condition that are commonly used for forming an insulation layer of the printed wiring board can be employed. For example, the roughening treatment of the insulation layer can be performed by carrying out a swelling treatment with a swelling liquid, a roughening treatment with an oxidizing agent, and a neutralizing treatment with a neutralizing liquid, in this order.

The swelling liquid used for the roughening treatment is not particularly limited. However, examples thereof may include an alkaline solution and a surfactant solution. Of these, an alkaline solution is preferable. As the alkaline solution, a sodium hydroxide solution and a potassium hydroxide solution are more preferable. Examples of a commercially available swelling liquid may include "SWELLING DIP SECURIGANTH P" and "SWELLING DIP SECURIGANTH SBU" manufactured by Atotech Japan K.K. The swelling treatment with the swelling liquid is not particularly limited. However, the swelling treatment can be performed by, for example, immersing the insulation layer in the swelling liquid at 30°C to 90°C for 1 minute to 20 minutes. From the viewpoint of restraining swelling of the resin in the insulation layer to an appropriate level, it is preferable to immerse the insulation layer in the swelling liquid at 40°C to 80°C for 5 minutes to 15 minutes.

The oxidizing agent used in the roughening treatment is not particularly limited. However, examples of the oxidizing agent may include an alkaline permanganate solution in which potassium permanganate or sodium permanganate is dissolved in an aqueous solution of sodium hydroxide. The roughening treatment with the oxidizing agent such as the alkaline permanganate solution is preferably performed by immersing the insulation layer in the oxidizing agent solution heated to 60°C to 100°C for 10 minutes to 30 minutes. Furthermore, a concentration of the permanganate in the alkaline permanganate solution is preferably 5% by mass to 10% by mass. Examples of a commercially available oxidizing agent may include an alkaline permanganate solution such as "CONCENTRATE COMPACT CP" or "DOSING SOLUTION SECURIGANS P" manufactured by Atotech.

Furthermore, the neutralizing liquid used for the roughening treatment is preferably an acidic aqueous solution. Examples of a commercially available neutralizing liquid may include "REDUCTION SOLUTION SECURIGANTH P" manufactured by Atotech.

The treatment with the neutralizing liquid can be performed by immersing the treated surface, which has been subjected to the roughening treatment with the oxidizing agent, in the neutralizing liquid at 30°C to 80°C for 5 minutes to 30 minutes. From the viewpoint of workability and the like, a method of immersing the object, which has been subjected to the roughening treatment with the oxidizing agent, in the neutralizing liquid at 40°C to 70°C for 5 minutes to 20 minutes is preferable.

The step (V) is a step of forming a conductive layer, whereby the conductive layer is formed on the insulation layer. A conductor material used for the conductive layer is not particularly limited. In a preferred embodiment, the conductive layer includes one or more types of metal selected from the group consisting of gold, platinum, palladium, silver, copper, aluminum, cobalt, chromium, zinc, nickel, titanium, tungsten, iron, tin, and indium. The conductive layer may be a single metal layer or an alloy layer. Examples of the alloy layer may include a layer formed of an alloy of two or more different metal selected from the above-mentioned group (e.g., a nickel-chromium alloy, a copper-nickel alloy, and a copper-titanium alloy). Of these, from the viewpoint of versatility and costs for forming the conductive layer, easiness of patterning, and the like, a single metal layer of chromium, nickel, titanium, aluminum, zinc, gold, palladium, silver, or copper, or an alloy layer of a nickel-chromium alloy, a copper-nickel alloy, or a copper-titanium alloy is preferable. A single metal layer of chromium, nickel, titanium, aluminum, zinc, gold, palladium, silver, or copper, or an alloy layer of a nickel-chromium alloy is more preferable, and a single metal layer of copper is still more preferable.

The conductive layer may have a single layer structure or a multi-layer structure in which two or more single metal layers or alloy layers formed of different types of metal or alloys are laminated. In a case where the conductive layer has the multilayer structure, a layer in contact with the insulation layer is preferably a single metal layer of chromium, zinc, or titanium, or an alloy layer of a nickel-chromium alloy.

The thickness of the conductive layer is generally 3 µm to 35 µm, preferably 5 µm to 30 µm, depending on a desired design of the printed wiring board.

In an embodiment, the conductive layer may be formed by plating. For example, the conductive layer having a desired wiring pattern can be formed by plating the surface of the insulation layer by a conventionally known technique such as a semi-additive method or a full-additive method. From the viewpoint of simplicity in the production, the conductive layer is preferably formed by the semi-additive method. An example of forming the conductive layer by the semi-additive method will be described below.

First, a plating seed layer is formed on the surface of the insulation layer by electroless plating. Next, a mask pattern is formed on the plating seed layer thus formed to expose a part of the plating seed layer corresponding to a desired wiring pattern. After a metal layer is formed on the exposed plating seed layer by electroplating, the mask pattern is removed. Subsequently, the unnecessary plating seed layer is removed by etching or the like to form the conductive layer having a desired wiring pattern.

In another embodiment, the conductive layer may be formed using a metal foil. In a case where the metal foil is used to form the conductive layer, the step (V) is performed preferably between the step (I) and the step (II). For example, after the step (I), the support is removed, and then the metal foil is laminated on the exposed surface of the resin composition layer. Lamination of the resin composition layer and the metal foil may be performed by a vacuum lamination method. A lamination condition may be the same as the condition described for the step (I). Next, the step (II) is performed to form the insulation layer. Subsequently, the conductive layer having a desired wiring pattern can be formed using the metal foil on the insulation layer by a conventional known technique such as a subtractive method or a modified semi-additive method.

The metal foil can be produced by a known method such as, for example, an electrolysis method or a rolling method. Examples of a commercially available metal foil may include HLP foil and JXUT-III foil manufactured by JX Nippon Mining & Metals Corp. and 3EC-III foil and TP-III foil manufactured by Mitsui Mining & Smelting Co., Ltd.

Alternatively, as described above, in the case where the metal foil or the metal foil with supporting substrate is used as the support for the resin sheet, the conductive layer may be formed using the metal foil.

### [Semiconductor chip package]

The semiconductor chip package of the present invention includes a sealing layer formed of the cured product of the resin composition of the present invention. As described above, the semiconductor chip package of the present invention may also include an insulation layer for forming a redistribution layer (redistribution forming layer), which is formed of the cured product of the resin composition of the present invention.

The semiconductor chip package can be produced, for example, using the resin composition or the resin sheet of the present invention by a method including the following steps (1) to (6). The resin composition or the resin sheet of the present invention may be used to form a sealing layer in the step (3) or a redistribution forming layer in the step (5). An example of forming the sealing layer and the redistribution forming layer using the resin composition or the resin sheet will be described below. However, a technique for forming the sealing layer and the redistribution forming layer of the semiconductor chip packages is known, and those skilled in the art can produce the semiconductor package according to the known technique using the resin composition or the resin sheet of the present invention:
(1) a step of laminating a temporary fixing film on a substrate;
(2) a step of temporarily fixing a semiconductor chip on the temporary fixing film;
(3) a step of forming a sealing layer on the semiconductor chip;
(4) a step of peeling off the substrate and the temporary fixing film from the semiconductor chip;
(5) a step of forming a redistribution forming layer as an insulation layer on the surface of the semiconductor chip from which the substrate and the temporary fixing film have been peeled off; and
(6) a step of forming a redistribution layer as a conductive layer on the redistribution forming layer

### -Step (1)-

A material used for the substrate is not particularly limited. Examples of the substrate may include: a silicon wafer; a glass wafer; a glass substrate; a metal substrate such as copper, titanium, stainless steel, and steel plate cold commercial (SPCC); a substrate prepared by impregnating a glass fiber with an epoxy resin or the like, followed by a thermal curing treatment (e.g., FR-4 substrate); and a substrate made of a bismaleimide triazine resin (BT resin).

A material of the temporary fixing film is not particularly limited as long as the temporary fixing film can temporarily fix the semiconductor chip and can be peeled off from the semiconductor chip in the step (4). A commercially available product can be used as the temporary fixing film. Examples of the commercially available product thereof may include REVALPHA manufactured by Nitto Denko Corp.

### -Step (2)-

The temporal fixing of the semiconductor chip can be performed using a known device such as a flip chip bonder or a die bonder. Arrangement layout and the installation number of the semiconductor chips can be appropriately determined according to the shape and size of the temporary fixing film, the production number of the semiconductor packages of interest, and the like. For example, the semiconductor chips can be arranged in a matrix form of multiple rows and multiple columns and temporarily fixed.

### -Step (3)-

The resin composition layer of the resin sheet of the present invention is laminated on the semiconductor chip, or the resin composition of the present invention is applied onto the semiconductor chip and then cured (e.g., thermally cured), to form a sealing layer.

For example, the lamination of the semiconductor chip and the resin sheet can be performed by removing the protective film from the resin sheet and performing thermocompression bonding of the resin sheet to the semiconductor chip from the support side. Examples of a member for performing the thermocompression bonding of the resin sheet to the semiconductor chip (hereinafter also referred to as "thermocompression bonding member") may include a heated metal plate (a SUS head plate, etc.) and a heated metal roll (a SUS roll). Further, it is preferable that, instead of directly pressing the thermocompression member onto the resin sheet, the thermocompression member is pressed onto the resin sheet through an elastic material such as heat-resistant rubber so that the resin sheet sufficiently follows the uneven surface of the semiconductor chip. The lamination of the semiconductor chip and the resin sheet may be performed by a vacuum lamination method, and a condition for the lamination is the same as the lamination condition described in relation to the method for producing the printed wiring board. Preferable ranges thereof are also the same.

After the lamination, the resin composition is thermally cured to form a sealing layer. A thermal curing condition is the same as the thermal curing condition described in relation to the method for producing the printed wiring board.

The support of the resin sheet may be peeled off after the resin sheet is laminated onto the semiconductor chip and thermally cured, or the support may be peeled off before the resin sheet is laminated onto the semiconductor chip.

In a case where the resin composition of the present invention is applied to form a sealing layer, a condition for the application is the same as the application condition for forming the resin composition layer described in relation to the resin sheet of the present invention. Preferable ranges thereof are also the same.

### -Step (4)-

A method for peeling off the substrate and the temporary fixing film can be appropriately changed according to the material of the temporary fixing film and the like. Example of the method may include a method in which the temporary fixing film is peeled off by heating and foaming (or expanding) the temporary fixing film and a method in which the temporary fixing film is peeled off by irradiating the film with ultraviolet rays from the substrate side and thereby reducing the adhesive force of the temporary fixing film.

In the method in which the temporary fixing film is peeled off by heating and foaming (or expanding) the temporary fixing film, a heating condition is usually 100 to 250°C for 1 to 90 seconds or 5 to 15 minutes. Furthermore, in the method in which the temporary fixing film is peeled off by irradiating the film with ultraviolet rays from the substrate side and thereby reducing the adhesive force of the temporary fixing film, an irradiation dose of ultraviolet rays is usually 10 mJ/cm² to 1000 mJ/cm².

### -Step (5)-

A material for forming the redistribution forming layer (insulation layer) is not particularly limited as long as insulation properties are exhibited when the redistribution forming layer (insulation layer) is formed. From the viewpoint of easiness in the production of the semiconductor chip package, an ultraviolet-curable resin or a thermosetting resin is preferable. The redistribution forming layer may be formed using the resin composition or the resin sheet of the present invention.

After the redistribution forming layer is formed, a via hole may be formed in the redistribution forming layer for interlayer connection between the semiconductor chip and a conductive layer described below. The via hole may be formed by a known method depending on the material of the rewiring forming layer.

### -Step (6)-

The formation of the conductive layer on the redistribution forming layer may be performed in the same manner as the step (V) described in relation to the method for producing the printed wiring board. Note that the step (5) and the step (6) may be repeated to alternately laminate (build up) the conductive layers (redistribution layers) and the redistribution forming layers (insulation layers).

In the production of the semiconductor chip package, a step (7) of forming a solder resist layer on the conductive layer (redistribution layer), a step (8) of forming a bump, and a step (9) of dicing a plurality of semiconductor chip packages into individual semiconductor chip packages, thereby separating them as individual pieces, may be further performed. These steps may be performed according to various methods known to those skilled in the art used in the production of the semiconductor chip package.

When the sealing layer and the redistribution forming layer are formed by using the resin composition or the resin sheet of the present invention that achieves a cured product exhibiting excellent dielectric properties, regardless of whether the semiconductor package is a fan-in type package or a fan-out type package, it is possible to achieve the semiconductor chip package with extremely low transmission loss. In an embodiment, the semiconductor chip package of the present invention is a fan-out type package. The resin composition or the resin sheet of the present invention can be applied for both fan-out panel level packaging (FOPLP) and fan-out wafer level packaging (FOWLP). In an embodiment, the semiconductor package of the present invention is a product of the fan-out panel level packaging (FOPLP). In another embodiment, the semiconductor package of the present invention is a product of the fan-out wafer level packaging (FOWLP).

### [Semiconductor device]

A semiconductor device of the present invention includes a layer formed of the cured product of the resin composition layer of the present invention. The semiconductor device of the present invention can be produced by using the printed wiring board or the semiconductor chip package of the present invention.

Examples of the semiconductor device may include various semiconductor devices used in electrical products (e.g., a computer, a mobile phone, a digital camera, a television, etc.) and vehicles (e.g., a motorcycle, an automobile, a train, a ship, an aircraft, etc.).

### Examples

### <Example 1> Synthesis of polyester resin (1)

### (1) Synthesis of aromatic dihydroxy oligomer compound (1)

In a 5-liter four-neck round flask equipped with a stirrer, a thermometer, a condenser, a dropping funnel, and a Dean Stark trap, 561.0 g of a cyclopentadiene-modified phenol resin ("J-DPP85" manufactured by JFE Chemical Corporation, a hydroxyl equivalent: 165 g/eq.), 151.2 g (0.7 mole) of 1,4-dibromobutane (reagent), 7 g of tetra-n-butylammonium bromide (reagent) used as a phase transfer catalyst, and 1,400 g of methyl isobutyl ketone (MIBK) as a reaction solvent were charged so that a composition ratio would be such that the m value in the theoretical structural formula becomes 0.7 in the theoretical structure shown below. The mixture was heated up to 100°C to completely dissolve the added components. To this mixture, 245.0 g (2.1 moles) of a 48% KOH aqueous solution was added dropwise over 1 hour. The distillate was separated into water and MIBK in the Dean Stark trap and allowed to react while only MIBK was being returned to the reaction system. Furthermore, the reaction continued for 6 hours in a temperature range of 110 to 125°C while the water was distilled off and only MIBK was being returned to the system. After that, the temperature was lowered to 60°C, and 300 g of distilled water and a hydrochloric acid water in an amount appropriate for neutralization were added and allowed to stand for liquid separation. A lower by-product saline layer was discarded. The same amount of distilled water was added, followed by two sets of washing and purification. Then, the resulting liquid was heated and subjected to azeotropic dehydration. The solution was subjected to microfiltration to remove impurities, and then MIBK was distilled under reduced pressure at a maximum temperature of 180°C to obtain 540 g of a solid.

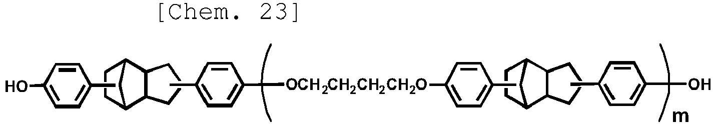

The hydroxyl equivalent of the solid was measured according to the following measurement method to obtain a value of 295 g/eq. (theoretical value: 299 g/eq.). In the mass spectrum obtained according to the following measurement method, respective spectral peaks of m/z = 694, which corresponds to a compound where m = 1, and m/z = 1069, which corresponds to a compound where m = 2, were detected. From these analytical data, it was confirmed that the obtained solid had the target molecular structure, that is, the structure of the aromatic dihydroxy oligomer compound (1) according to the above-mentioned theoretical structure.

### (Measurement method of hydroxyl equivalent)

According to JIS-K0070, hydroxyl groups in the phenol resin were acetylated with acetic anhydride-pyridine and then hydrolyzed, and the remaining acetic acid was back-titrated to determine the hydroxyl equivalent.

The sample was diluted with THF to 1 mg/mL and LC/MS measurement was performed under the following conditions.

### (Measurement method of mass spectrum)

HPLC: ACQUITY UPLC (manufactured by Nihon Waters K.K.)
MS: SQ Detector2 (manufactured by Nihon Waters K.K.)
Column: ACQUITY UPLC BEH C8 1.7 µm, 2.1 mm × 50 mm (manufactured by Nihon Waters K.K.)
Mobile phase A: 2-mmol ammonium acetate aqueous solution
Mobile phase B: 2-propanol / THF (80:20)
Mobile phase mixing time and mixing ratio (A%): 0 min.
(50%) → 5 min. (5%) → 12 min. (5%) → 12.1 min. (50%) → 14 min. (50%)
Flow rate: 0.25 mL/min.
Analysis time: 14 minutes
Column temperature: 40°C
Ion mode: ESI (electrospray ionization) positive
Ionic polarity: Negative detection mode
Desolvation gas flow rate: 700 L/hr, 250°C
Cone gas: 70 L/hr
Ion source heater: 150°C

### (2) Esterification reaction - Synthesis of polyester resin (1) -

In a 1-liter four-neck round flask equipped with a stirrer, a thermometer, a dropping funnel, and a nitrogen gas inlet, 120 g of the above-mentioned aromatic dihydroxy oligomer compound (1) (hydroxy group: 0.4 mole) obtained in the above-mentioned (1), 28.8 g (0.2 mole) of 1-naphthol, 60.9 g (0.3 mole) of isophthalic chloride, 2 g of tetra-n-butylammonium bromide, and 400 g of toluene were charged so that a composition ratio would be such that the n value in the theoretical structural formula becomes 2.0 in the following theoretical structure and that the equivalent weight of the active ester group becomes 308 g/eq. While nitrogen gas was blown, the mixture was stirred to be completely dissolved. To this mixture, 98.0 g (0.61 mole) of a 25% caustic soda aqueous solution was added dropwise over 1 hour at 30°C, with careful attention to heat generation, until a final temperature of 60°C was reached. Then, after the mixture was further continuously stirred at 60°C for 2 hours, 100 g of distilled water was added to the mixture and allowed to stand for liquid separation. A lower by-product saline layer was discarded. The same amount of distilled water was added, followed by two sets of washing and purification. Then, the resulting liquid was heated and subjected to azeotropic dehydration. The solution was subjected to microfiltration to remove impurities, and then toluene was distilled under reduced pressure at a maximum temperature of 200°C to obtain 171 g of a solid.

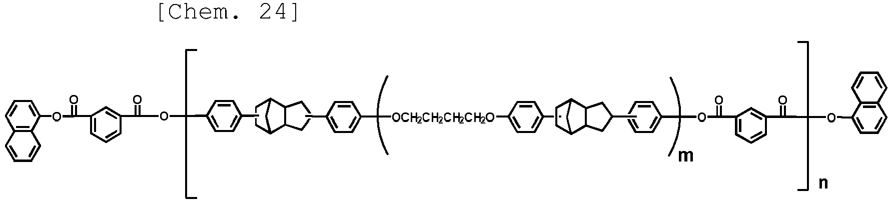

Mass spectrum of the obtained solid was measured to detect respective spectral peaks of m/z = 1243, which corresponds to a compound where n = 1, and m/z = 1618, which corresponds to a compound where n = 1 / m = 2. From these analytical data, it was confirmed that the obtained solid had the target molecular structure, that is, the structure of the polyester resin (1) according to the above-mentioned theoretical structure.

### <Example 2> Synthesis of polyester resin (2)

### (1) Synthesis of aromatic dihydroxy oligomer compound (2)

A solid in an amount of 601 g was obtained in the same manner as in the procedure (1) of Example 1 except that 1,4-dibromobutane was changed to 122.5 g (0.7 mole) of paraxylene dichloride (reagent) so that a composition ratio would be such that the m value in the theoretical structural formula becomes 0.7 in the following theoretical structure.

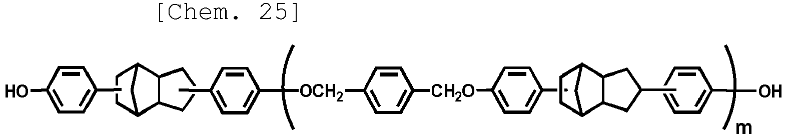

The hydroxyl equivalent of the solid was 309 g/eq. (theoretical value: 316 g/eq.), and in the mass spectrum, respective spectral peaks of m/z = 742, which corresponds to a compound where m = 1, and m/z = 1165, which corresponds to a compound where m = 2, were detected. From these analytical data, it was confirmed that the obtained solid had the target molecular structure, that is, the structure of the aromatic dihydroxy oligomer (2) according to the above-mentioned theoretical structure.

### (2) Esterification reaction - Synthesis of polyester resin (2) -

A solid in an amount of 178 g was obtained in the same manner as in the procedure (2) of Example 1 except that the aromatic dihydroxy oligomer compound (1) was changed to 126.4 g of the aromatic dihydroxy oligomer compound (2) so that a composition ratio would be such that the n value in the theoretical structural formula becomes 2.0 in the following theoretical structure and the equivalent weight of the active ester group becomes 312 g/eq.

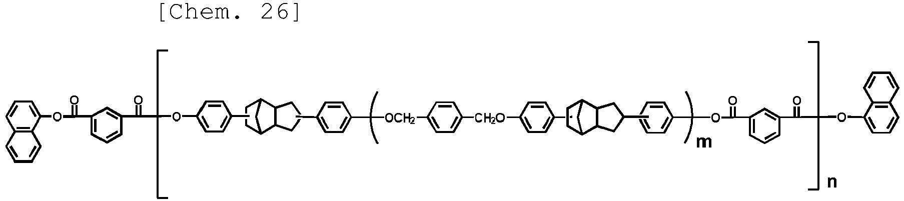

In the mass spectrum, respective spectral peaks of m/z = 1291, which corresponds to a compound where n = 1 / m = 1, and m/z = 2164, which corresponds to a compound where n = 2 / m = 1, were detected. From these analytical data, it was confirmed that the obtained solid had the target molecular structure, that is, the structure of the polyester resin (2) according to the above-mentioned theoretical structure.

### <Example 3> Synthesis of polyester resin (3)

### (1) Synthesis of aromatic dihydroxy oligomer compound (3)

A solid in an amount of 650 g was obtained in the same manner as in the procedure (1) of Example 1 except that the dicyclopentadiene-modified phenol resin was changed to 616.0 g (2.0 moles) of 2,2-bis(3-allyl-4-hydroxyphenyl)propane, 1,4-dibromobutane was changed to 244.0 g (1.0 mole) of 1,6-dibromohexane, and the amount of the 48% KOH aqueous solution was changed to 350 g (3.0 moles) so that a composition ratio would be such that the m value in the theoretical structural formula becomes 1.0 in the following theoretical structure.

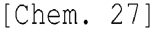

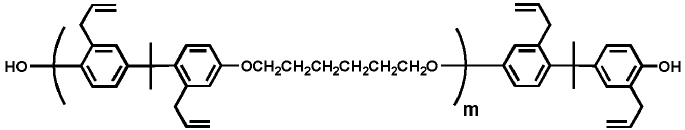

The hydroxyl equivalent of the obtained solid was 336 g/eq. (theoretical value: 350 g/eq.), and in the mass spectrum, respective spectral peaks of m/z = 699, which corresponds to a compound where m = 1, and m/z = 1090, which corresponds to a compound where m = 2, were detected. From these analytical data, it was confirmed that the obtained solid had the target molecular structure, that is, the structure of the aromatic dihydroxy oligomer (3) according to the above-mentioned theoretical structure.

### (2) Esterification reaction - Synthesis of polyester resin (3)

A solid in an amount of 210 g was obtained in the same manner as in the procedure (2) of Example 1 except that (i) the aromatic dihydroxy oligomer compound (1) was changed to 139.6 g of the aromatic dihydroxy oligomer compound (3) obtained above, (ii) 1-naphthol was changed to 53.6 g (0.40 mole) of 2-allylphenol, (iii) the amount of isophthalic chloride was changed to 81.2 g (0.40 mole), and (iv) the amount of the 25% NaOH aqueous solution was changed to 130.6 g (0.8 mole) so that a composition ratio would be such that the n value in the theoretical structural formula becomes 1.0 in the following theoretical structure and the equivalent weight of the active ester group becomes 307 g/eq.

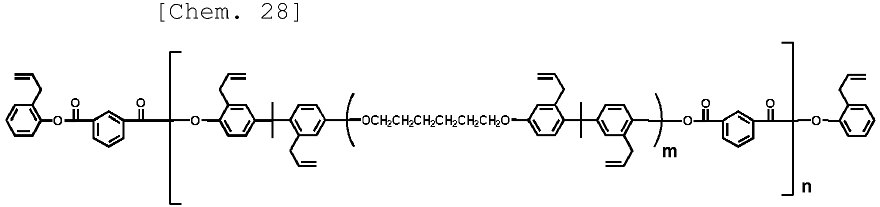

In the mass spectrum of the obtained solid, respective spectral peaks of m/z = 1228, which corresponds to a compound where n = 1 / m = 1, and m/z = 2057, which corresponds to a compound where n = 2 / m = 1, were detected. From these analytical data, it was confirmed that the obtained solid had the target molecular structure, that is, the structure of the polyester resin (3) according to the above-mentioned theoretical structure.

### <Example 4> Synthesis of polyester resin (4)

### (1) Synthesis of aromatic dihydroxy oligomer compound (4)

A solid in an amount of 621 g was obtained in the same manner as in the procedure (1) of Example 1 except that the dicyclopentadiene-modified phenol resin was changed to 480.0 g (3.0 moles) of 2,7-dihydroxynaphthalene, 1,4-dibromobutane was changed to 350.0 g (2.0 moles) of paraxylene dichloride, and the amount of the 48% KOH aqueous solution was changed to 700.0 g (6.0 moles) so that a composition ratio would be such that the m value in the theoretical structural formula becomes 2.0 in the following theoretical structure.

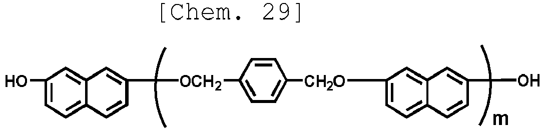

The hydroxyl equivalent of the obtained solid was 339 g/eq. (theoretical value: 342 g/eq.), and in the mass spectrum, respective spectral peaks of m/z = 422, which corresponds to a compound where m = 1, and m/z = 671, which corresponds to a compound where m = 2, were detected. From these analytical data, it was confirmed that the obtained solid had the target molecular structure, that is, the structure of the aromatic dihydroxy oligomer (4) according to the above-mentioned theoretical structure.

### (2) Esterification reaction - Synthesis of polyester resin (4)

A solid in an amount of 222 g was obtained in the same manner as in the procedure (2) of Example 1 except that (i) the aromatic dihydroxy oligomer compound (1) was changed to 136.8 g of the aromatic dihydroxy oligomer compound (4) obtained above, (ii) the amount of 1-naphthol was changed to 57.6 g (0.40 mole), (iii) the amount of isophthalic chloride was changed to 81 g (0.40 mole), and (iv) the amount of the 25% NaOH aqueous solution was changed to 131.6 g (0.82 mole) so that a composition ratio would be such that the n value in the theoretical structural formula becomes 1.0 in the following theoretical structure and the equivalent weight of the active ester group becomes 303 g/eq.

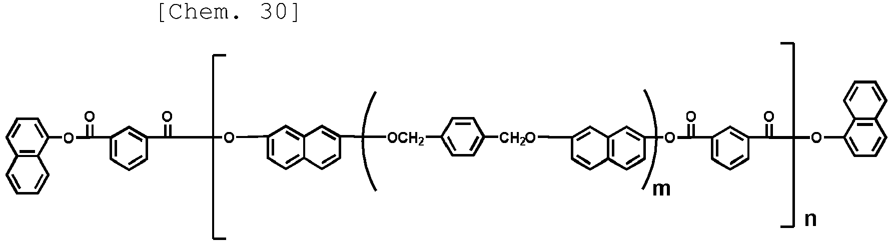

In the mass spectrum of the obtained solid, respective spectral peaks of m/z = 971, which corresponds to a compound where n = 1 / m = 1, and m/z = 1223, which corresponds to a compound where n = 1 / m = 2, were detected. From these analytical data, it was confirmed that the obtained solid had the target molecular structure, that is, the structure of the polyester resin (4) according to the above-mentioned theoretical structure.

### <Example 5> Synthesis of polyester resin (5)

### (1)Synthesis of aromatic dihydroxy oligomer compound (5)

In a 3-liter four-neck round flask equipped with a stirrer, a thermometer, a condenser, and a Dean Stark trap, 320.0 g (2.0 moles) of 2,7-dihydroxynaphthalene, 632.0 g (4.0 moles) of benzylalcohol, and 10 g of paratoluenesulfonic acid were added, and the mixture was stirred and dissolved. After that, the temperature was raised to 180°C and a dehydration reaction was performed for 3 hours to obtain an intermediate in which two benzyl groups were substituted on average on the naphthalene skeleton. Next, a solid in an amount of 371 g was obtained in the same manner as in the procedure (1) of Example 1 except that the dicyclopentadiene-modified phenol resin was changed to 510.0 g of the resulting intermediate, the amount of 1,4-dibromobutane was changed to 216.0 g (1.0 mole), and the amount of the 48% KOH aqueous solution was changed to 350.0 g (3.0 moles) so that a composition ratio would be such that the m value in the theoretical structural formula becomes 2.0 in the following theoretical structure.

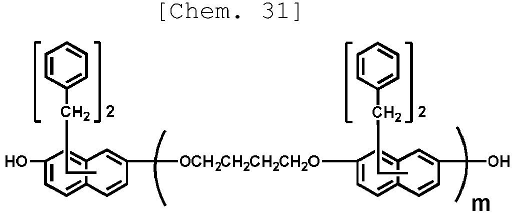

The hydroxyl equivalent of the obtained solid was 410 g/eq. (theoretical value: 402 g/eq.), and in the mass spectrum, respective spectral peaks of m/z = 735, which corresponds to a compound where m = 1, and m/z = 1129, which corresponds to a compound where m = 2, were detected. From these analytical data, it was confirmed that the obtained solid had the target molecular structure, that is, the structure of the aromatic dihydroxy oligomer (5) according to the above-mentioned theoretical structure.

### (2) Esterification reaction - Synthesis of polyester resin (5)

A solid in an amount of 242 g was obtained in the same manner as in the procedure (2) of Example 1 except that (i) the aromatic dihydroxy oligomer compound (1) was changed to 160.8 g of the aromatic dihydroxy oligomer compound (5) obtained above, (ii) 1-naphthol was changed to 60.0 g (0.40 mole) of para-tertiary butyl phenol, (iii) the amount of isophthalic chloride was changed to 81.2 g (0.40 mole), and (v) the amount of the 25% NaOH aqueous solution was changed to 130.6 g (0.82 mole) so that a composition ratio would be such that the n value in the theoretical structural formula becomes 1.0 in the following theoretical structure and the equivalent weight of the active ester group becomes 341 g/eq.

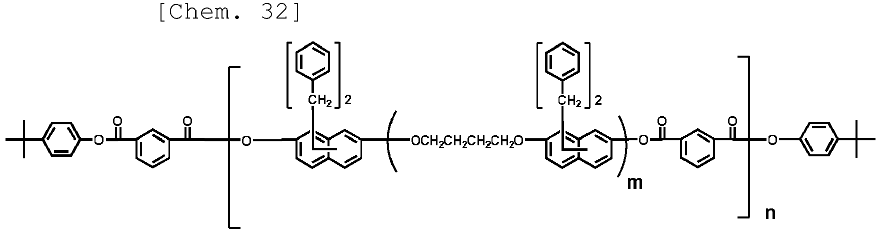

In the mass spectrum of the obtained solid, respective spectral peaks of m/z = 1296, which corresponds to a compound where n = 1 / m = 1, and m/z = 1690, which corresponds to a compound where n = 1 / m = 2, were detected. From these analytical data, it was confirmed that the obtained solid had the target molecular structure, that is, the structure of the polyester resin (5) according to the above-mentioned theoretical structure.

### <Example 6>

### (1) Preparation of resin composition

The synthesized polyester resin (1) in an amount of 31 g and a bisphenol A type liquid epoxy resin ("850S" manufactured by manufactured by DIC Corp., epoxy equivalent: 183 g/eq.) in an amount of 19 g were melted and mixed at 150°C. Then, 0.5 g of dimethylaminopyridine was mixed thereto to prepare a resin composition. Chemical composition is shown in Table 1.

### (2) Production of cured product

The resin composition thus prepared was filled into a mold (100 mm × 100 mm × 2 mm), which was coated with a mold release agent, and thermally cured at 150°C for 10 minutes. The cured product was removed from the mold. The cured product was further thermally cured at 200°C for 3 hours to prepare a sheet-like cured product.

### <Example 7>

A resin composition was prepared and a cured product was produced in the same manner as in Example 6 except that 32 g of the polyester resin (2) was used instead of the polyester resin (1).

### <Example 8>

A resin composition was prepared and a cured product was produced in the same manner as in Example 6 except that 31 g of the polyester resin (3) was used instead of the polyester resin (1).

### <Example 9>

A resin composition was prepared and a cured product was produced in the same manner as in Example 6 except that 30 g of the polyester resin (4) was used instead of the polyester resin (1).

### <Example 10>

A resin composition was prepared and a cured product was produced in the same manner as in Example 6 except that 34 g of the polyester resin (5) was used instead of the polyester resin (1).

### <Comparative Example 1>

A resin composition was prepared and a cured product was produced in the same manner as in Example 6 except that 22 g of a solid resin obtained by desolvating an active ester resin ("HPC-8000-65T" manufactured by DIC Corp., equivalent weight of active ester group: 220 g/eq.) was used instead of the polyester resin (1).

The cured products produced in Examples 6 to 10 and Comparative Example 1 were subjected to evaluation tests according to the descriptions below. Table 2 shows the results.

### [Dielectric properties]

The cured product was cut into a test piece with a predetermined size, and was used to measure the dielectric constant and dielectric loss tangent with a cavity resonance method at a measurement frequency of 5.8 GHz and a temperature of 23°C using a cavity resonator perturbation method-based dielectric constant measuring device ("CP521" manufactured by Kanto Electronics Application & Development Inc.) and a network analyzer ("E8362B" manufactured by Agilent Technologies Japan, Ltd.). For each cured product, five test pieces were measured (n = 5) to calculate their average value.

### [Table 1].

**(Table 1)**

| | | | Examples | | | | | Comparative Example |
|---|---|---|---|---|---|---|---|---|
| | | | 6 | 7 | 8 | 9 | 10 | 1 |
| Blending components (parts by mass*) | Polyester resin | (1) | 31 | | | | | |
| | | (2) | | 32 | | | | |
| | | (3) | | | 31 | | | |
| | | (4) | | | | 30 | | |
| | | (5) | | | | | 34 | |
| | | HPC-8000-65T | | | | | | 22 |
| | 850S | | 19 | 19 | 19 | 19 | 19 | 19 |
| | DMAP | | 0.5 | 0.5 | 0.5 | 0.5 | 0.5 | 0.5 |

| | | | | | | | | |
|---|---|---|---|---|---|---|---|---|
| * In terms of nonvolatile component HPC-8000-65T: Active ester resin (manufactured by DIC Corp., equivalent weight of active ester group of 220g/eq.) 850S: Bisphenol A type liquid epoxy resin (manufactured by DIC Corp., equivalent weight of epoxy group of 183g/eq.) DMAP: 4-Dimethylaminopyridine (manurafatured by Koei Chemical Co., Ltd.) | | | | | | | | |

### [Table 2]

**(Table 2)**

| | | **Dielectric properties** | |
|---|---|---|---|
| | | **Dielectric constant** | **Dielectric loss tangent** |
| **Examples** | **6** | **2.6** | **0.0055** |
| | **7** | **2.7** | **0.0052** |
| | **8** | **2.6** | **0.0061** |
| | **9** | **2.6** | **0.0049** |
| | **10** | **2.5** | **0.0048** |
| **Comparative Example** | **1** | **2.9** | **0.0082** |

### <Example 11>

### (1) Preparation of resin composition

Fifteen parts of a bisphenol A type liquid epoxy resin ("850S" manufactured by DIC Corp., epoxy equivalent: 183 g/eq.) and 15 parts of a biphenyl aralkyl type epoxy resin ("NC3000H" manufactured by Nippon Kayaku Co., Ltd., epoxy equivalent: 291 g/eq.) were heated and dissolved in 15 parts of methyl ethyl ketone (MEK) and 30 parts of cyclohexanone while being stirred. Then, 38 parts of the synthesized polyester resin (1), 0.15 part of a curing accelerator (manufactured by Koei Chemical Co., Ltd.; 4-dimethylaminopyridine (DMAP)), 400 parts of spherical silica ("SO-C2" manufactured by Admatechs, average particle diameter: 0.5 µm, with phenylanosilane treatment, carbon content per unit mass: 0.180), and 15 parts of a phenoxy resin ("YL6954BH30" manufactured by Mitsubishi Chemical Corporation, MEK solution with solid content of 30 mass%, weight-average molecular weight: 40,000) were mixed and uniformly dispersed by a high-speed rotating mixer to prepare a resin composition varnish.

### (2) Preparation of resin sheet

The resin composition varnish thus prepared was applied onto a polyethylene terephthalate (thickness: 38 µm, hereinafter abbreviated as "PET film") by a die coater so that the thickness of the dried resin composition layer became 40 µm. The resin composition was dried at 80 to 120°C (average: 100°C) for 6 minutes to prepare a resin sheet.

### (3) Production of cured product

The resin sheet thus prepared was heated at 190°C for 120 minutes to thermally cure the resin composition layer. Then, the PET film was peeled off to obtain a sheet-like cured product.

### <Examples 12 to 15 and Comparative Example 2>

Resin composition varnishes, resin sheets, and cured products were produced in the same manner as in Example 11 except that the chemical composition was changed to those shown in Table 3 described below.

The cured products produced in Examples 11 to 15 and Comparative Example 2 were subjected to the evaluation test of the dielectric properties in the same manner as in Example 6 and the like. In addition, the evaluation test of the mechanical properties was conducted in the following manner. The results are shown in Table 4.

### [Mechanical properties]

The cured product was cut into a test piece with a predetermined size. The test piece of the cured product was subjected to a tensile test using a Tensilon universal testing machine ("RTC-1250A" manufactured by Orientec Co., Ltd.) according to Japanese Industrial Standard (JIS K7127), so that the elongation at break was measured.

### [Table 3]

**(Table 3)**

| | | | Examples | | | | | Comparative Example |
|---|---|---|---|---|---|---|---|---|
| | | | 11 | 12 | 13 | 14 | 15 | 2 |
| Blending components (parts by mass*) | Polyester resin | (1) | 38 | | | | | |
| | | (2) | | 38 | | | | |
| | | (3) | | | 38 | | | |
| | | (4) | | | | 38 | | |
| | | (5) | | | | | 38 | |
| | | HPC-8000-65T | | | | | | 38 |
| | 850S | | 19 | 19 | 19 | 19 | 19 | 19 |
| | NC3000H | | 0.5 | 0.5 | 0.5 | 0.5 | 0.5 | 0.5 |
| | DMAP | | 0.15 | 0.15 | 0.15 | 0.15 | 0.15 | 0.15 |
| | YL6954BH30 | | 4.5 | 4.5 | 4.5 | 4.5 | 4.5 | 4.5 |
| | SO-C2 | | 400 | 400 | 400 | 400 | 400 | 400 |

| | | | | | | | | |
|---|---|---|---|---|---|---|---|---|
| * In terms of nonvolatile component 850S: Bisphenol A type liquid epoxy resin (manufactured by DIC Corp., equivalent weight of epoxy group of 183g/eq.) NC3000H: Biphenyl aralkyl type epoxy resin (manufactured by Nippon Kayaku Co., Ltd., equivalent weight of epoxy group of 291 g/eq.) HPC-8000-65T: Active ester resin (manufactured by DIC Corp., equivalent weight of active ester group of 220g/eq.) DMAP: 4-Dimethylaminopyridine (manurafatured by Koei Chemical Co., Ltd.) YL6954BH30: Phenoxy resin (manufactured by Mitsubishi Chemical Corporation) SO-C2: Spherical Silica (manufactured by Admatechs Co., Ltd.) | | | | | | | | |

### [Table 4]

**(Table 4)**

| | | Dielectric properties | | Mechanical properties |
|---|---|---|---|---|
| | | Dielectric constant | Dielectric loss tangent | Elongation at break (%) |
| Examples | 11 | 3.2 | 0.0029 | 1.9 |
| | 12 | 3.2 | 0.0028 | 1.6 |
| | 13 | 3.1 | 0.0027 | 2.0 |
| | 14 | 3.2 | 0.0025 | 1.9 |
| | 15 | 3.1 | 0.0025 | 1.8 |
| Comparative Example | 2 | 3.3 | 0.0035 | 1.2 |

As shown in Tables 2 and 4, it was confirmed that when the specific polyester resins of the present invention were used as a component of the resin composition, the dielectric properties and the mechanical properties were improved as compared with a case where the conventional active ester resin was used. That is, the resin composition using the specific polyester resin and the cured product of the resin composition according to the present invention can achieve the low transmission loss required under a high-frequency environment, such as that used by a 5G device, at a high level without sacrificing reliability.

## Claims

1. A polyester resin (X) containing a structural unit represented by the following general formula (1), the polyester resin (X) having an aromatic oxycarbonyl group at its terminal: 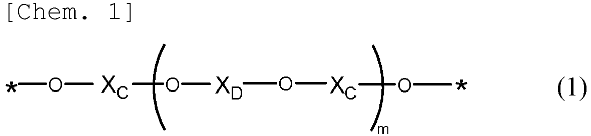 (in the formula,
X_{C}s each independently represent a divalent organic group containing at least one aromatic ring,
X_{D}s each independently represent a divalent organic group,
m is an average value of a number of repetitions, and is a number satisfying 0 < m ≤ 10, and
* indicates a bond).

2. The polyester resin (X) according to claim 1, wherein the X_{D} represents
(i) a divalent aliphatic hydrocarbon group, or
(ii) a divalent organic group represented by the following formula (d2-1) or (d2-2): 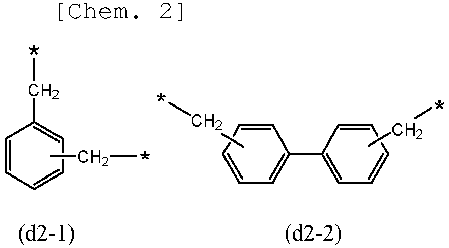 (in the formula, * represents a bond).

3. The polyester resin (X) according to claim 1, wherein an oxygen atom bonded to the X_{C} in the general formula (1) is bonded to an aromatic carbon of the X_{C}.

4. The polyester resin (X) according to claim 1, wherein the X_{C}s are each independently represented by the following formula (C-1), formula (C-2), or formula (C-3): 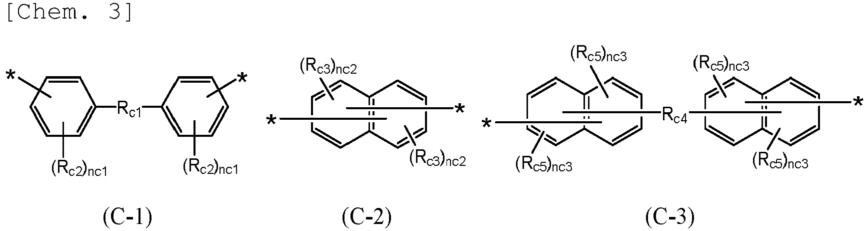 (in the formulas,
R_{c1}s and R_{c4}s each independently represent a single bond, or a divalent linking group selected from the group consisting of a divalent hydrocarbon group of 1 to 10 carbon atoms optionally having a substituent, an oxygen atom, a sulfonyl group, a carbonyl group, a carbonate group, and a combination thereof,
R_{c2}S, R_{c3}S, and R_{c5}s each independently represent a substituent,
nc1, nc2, and nc3 each independently represent a number of 0 to 4, and
* indicates a bond).

5. The polyester resin (X) according to claim 1, wherein m is a number satisfying 0 < m ≤ 3.

6. The polyester resin (X) according to claim 1, represented by the following general formula (X): 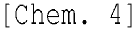 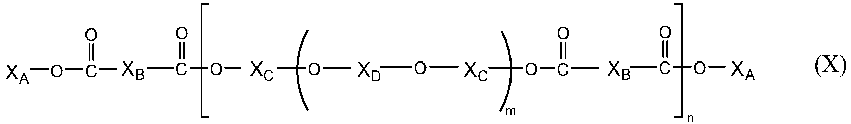 (in the formula,
X_{C}, X_{D} and m are the same as above,
X_{A}s each independently represent a monovalent aromatic group,
X_{B}s each independently represent a divalent organic group, and
n represents an average value of the number of repetitions, and is a number satisfying 0 < n ≤ 10).

7. The polyester resin (X) according to claim 6, wherein the X_{A}s are each independently represented by the following formula (A-1) or (A-2): 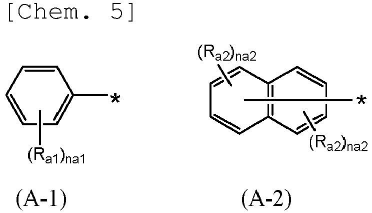 (in the formulas,
Rₐ₁ and Rₐ₂ each independently represent a substituent,
na1 represents a number of 0 to 5,
na2s each independently represent a number of 0 to 4, and
* represents a bond).

8. The polyester resin (X) according to claim 6, wherein m is a number satisfying 0 < m ≤ 3, and n is a number satisfying 0 < n ≤ 3.

9. The polyester resin (X) according to claim 1, wherein the polyester resin (X) is a condensation reaction product of:
(x1) an aromatic dihydroxy oligomer compound represented by the following general formula (x1);
(x2) a divalent organic carboxylic acid compound or a divalent organic carboxylic acid halide compound; and
(x3) a monovalent hydroxy compound having an aromatic hydroxy group: 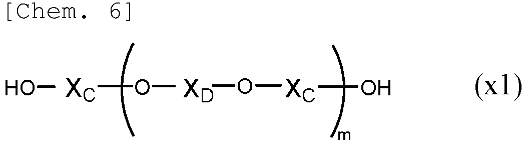 (in the formula, X_{C}, X_{D}, and m are the same as described above) .

10. The polyester resin (X) according to claim 9, wherein the aromatic dihydroxy oligomer compound (x1) is a dehydrohalogenation reaction product of a divalent aromatic hydroxy compound represented by the following general formula (x1-c), and a divalent organic halide compound represented by the following general formula (x1-d): 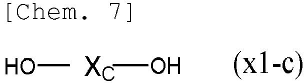 (in the formula, X_{C} is the same as described above); and 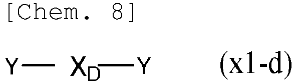 (in the formula, X_{D} is the same as described above, and Y represents a halogen atom).

11. The polyester resin (X) according to claim 10, wherein a hydroxyl equivalent of the divalent aromatic hydroxy compound is 150 g/eq. or more.

12. The polyester resin (X) according to claim 9, wherein a hydroxyl equivalent of the aromatic dihydroxy oligomer compound (x1) is 250 g/eq. or more.

13. The polyester resin (X) according to claim 1, wherein an equivalent weight of an active ester group is 250 g/eq. or more.

14. A resin cross-linking agent comprising the polyester resin (X) according to any one of claims 1 to 13.

15. A resin composition comprising the polyester resin (X) according to any one of claims 1 to 13, and a cross-linkable resin (Y).

16. The resin composition according to claim 15, wherein the cross-linkable resin (Y) is one or more types selected from the group consisting of a thermosetting resin and a radically polymerizable resin.

17. The resin composition according to claim 15, further comprising an inorganic filler.

18. The resin composition according to claim 15, further comprising an organic solvent.

19. The resin composition according to claim 15, for an insulation layer of a printed wiring board.

20. The resin composition according to claim 15, for sealing semiconductor.

21. A resin sheet comprising: a support; and a layer of the resin composition according to claim 15, disposed on the support.

22. The resin sheet according to claim 21, wherein the support is a thermoplastic resin film or a metal foil.

23. A prepreg formed by impregnating a sheet-like fiber substrate with the resin composition according to claim 15.

24. A cured product of the resin composition according to claim 15.

25. A printed wiring board comprising an insulation layer formed of a cured product of the resin composition according to claim 15.

26. A semiconductor chip package comprising a sealing layer formed of a cured product of the resin composition according to claim 15.

27. The semiconductor chip package according to claim 26, wherein the semiconductor chip package is a fan-out type package.

28. A semiconductor device comprising the printed wiring board according to claim 25.

29. A semiconductor device comprising the semiconductor chip package according to claim 26.
